# EUROPEAN PATENT SPECIFICATION

(11) **EP 4 328 030 B1**
(45) Date of publication and mention of the grant of the patent: **18.03.2026**
(21) Application number: 21937923.7
(22) Date of filing: 23.04.2021
(51) Int. Cl.: B41F 15/08, B41F 15/12, B41F 15/36, B41F 33/00, H05K 3/12, H05K 3/34

(54) **REPLACEMENT UNIT, PRINTING DEVICE AND CONTROL METHOD FOR REPLACEMENT UNIT**
AUSTAUSCHEINHEIT, DRUCKVORRICHTUNG UND STEUERUNGSVERFAHREN FÜR AUSTAUSCHEINHEIT
UNITÉ DE REMPLACEMENT, DISPOSITIF D'IMPRESSION ET PROCÉDÉ DE COMMANDE POUR UNITÉ DE REMPLACEMENT

(43) Date of publication of application: 28.02.2024
(73) Proprietor: Fuji Corporation, Chiryu-shi, Aichi 472-8686 (JP)
(72) Inventor: YOKOI, Yoshimune, Chiryu-shi, Aichi 472-8686 (JP); YAMAGIWA, Masato, Chiryu-shi, Aichi 472-8686 (JP); TANAKA, Motoki, Chiryu-shi, Aichi 472-8686 (JP)
(74) Representative: Grünecker Patent- und Rechtsanwälte PartG mbB
(86) International application number: PCT/JP2021/016430
(87) International publication number: WO 2022/224431

(56) References cited:
- EP-A1- 3 344 027
- EP-A1- 3 804 993
- WO-A1-2017/033268
- WO-A1-2020/065809
- WO-A1-2020/161830
- WO-A1-2020/217442
- JP-A- 2017 154 445
- JP-A- H09 300 581

## Description

### Technical Field

The present description discloses a replacement unit, a printing device, a mounting system, and a control method for a replacement unit.

### Background Art

Conventionally, for example, in printing devices for performing a printing process of printing a viscous fluid on a printing target object such as a board using a screen mask, there has been proposed a printing device in which printing-related members including a screen mask or the like for use in the printing device are automatically replaced (for example, refer to WO 2018/105016 A1). With this printing device, since the printing-related members can automatically be replaced, the load of an operator can be reduced much. In addition, in mounting systems in which such a printing device is used, there has been proposed a mounting system including a loader for replacing members for use in a mounting device for mounting a component on a processing target object such as a board and configured to specify a work area where an operator performs an operation to thereby cause the loader not to enter this specified work area (for example, refer to WO 2020/065809 A1). With this mounting system, the wasteful operation of the loader can be reduced. A similar loader capable of moving along the front of multiple mounting machines and a feeder storage container forming part of a mounting system to automatically exchange feeders is disclosed in EP 3 344 027 A1. The loader is provided with left and right monitoring sensors configured to detect the presence of an obstacle (operator) in a movement direction of the loader.

### Summary of the Invention

### Technical Problem

With the printing device described in WO 2018/105016 A1, however, an accommodation device is placed in front of the printing device, and printing-related members are automatically replaced between the printing device and the accommodation device; however, since the accommodation device is disposed at the front of the printing device, there has been a problem in that the printing device makes it difficult for the operator to perform his or her operation. In addition, as with the mounting device, the printing device is also required to secure the safety of the operator in the work area by detecting an object existing in the work area.

The present disclosure has been made in view of the problems described above, and a main object thereof is to provide a replacement unit, a printing device, a mounting system, and a control method for a replacement unit which can provide more safety in automatically replacing printing-related members for use in the printing device. Solution to Problem

A replacement unit according to claim 1, a printing device according to claim 14 and a control method for a replacement unit according to claim 15 are provided to achieve the main object described above.

Preferred embodiments of the invention are defined in the dependent claims.

A replacement unit according to the present invention is a replacement unit for a printing device including a printing section configured to perform a printing process of printing a viscous fluid on a processing target object using a screen mask,
the replacement unit including:
a moving section configured to receive an accommodation rack having multiple shelf sections for accommodating a printing-related member for use in the printing device and to move the accommodation rack between a replacement position where to replace the printing-related member and a standby position which lies further downwards than the replacement position; and
a region detection section configured to detect an object existing in a predetermined first detection region lying around a circumference of the replacement unit when the accommodation rack exists outside a predetermined movement region which lies between the standby position and the replacement position and which excludes the standby position and the replacement position, while being configured to detect an object existing in a second detection region which is different from the first detection region when the accommodation rack exists inside the movement region, wherein the object includes an operator.

With this replacement unit, when the accommodation rack accommodating the printing-related members exists outside the predetermined movement region which lies between the standby position and the replacement position, an object existing in the predetermined first detection region which lies around the circumference of the replacement unit is detected, whereas when the accommodation rack exists inside the movement region, an object existing in the second detection region which is different from the first detection region is detected. With this replacement unit, since the detection regions for objects can be changed appropriately in accordance with the position of the accommodation rack, more safety can be ensured for automatically replacing the printing-related members for use in the printing device.

### Brief Description of Drawings

Fig. 1 is a schematic explanatory diagram showing an example of mounting system 10 and printing device 11.
Fig. 2 is a schematic explanatory diagram of accommodation rack 80.
Fig. 3 is an explanatory diagram showing an example of rack moving section 43.
Fig. 4 is an explanatory diagram showing an example of printing device 11, replacement unit 40, and accommodation rack 80.
Fig. 5 is an explanatory diagram showing an example of mounting device 15 and loader 18.
Fig. 6 is an explanatory diagram illustrating a receipt of accommodation rack 80 and movement thereof between a standby position and a replacement position.
Fig. 7 is an explanatory diagram of first detection region 91, second detection region 92, and warning region 93.
Fig. 8 is a flowchart showing an example of a detection region setting process routine.
Fig. 9 is a flowchart showing an example of a printing-related member replacement process routine.
Fig. 10 is an explanatory diagram of first detection region 91 when accommodation rack 80 is in the standby position.
Fig. 11 is an explanatory diagram of second detection region 92 when accommodation rack 80 is in a movement region.
Fig. 12 is an explanatory diagram of first detection region 91 and lower surface region 94 when accommodation rack 80 is in the replacement position.
Fig. 13 is a flowchart showing an example of a mounting-related member replacement process routine.
Fig. 14 is an explanatory diagram of another second detection region 92B when accommodation rack 80 is in the movement region.

### Description of Embodiments

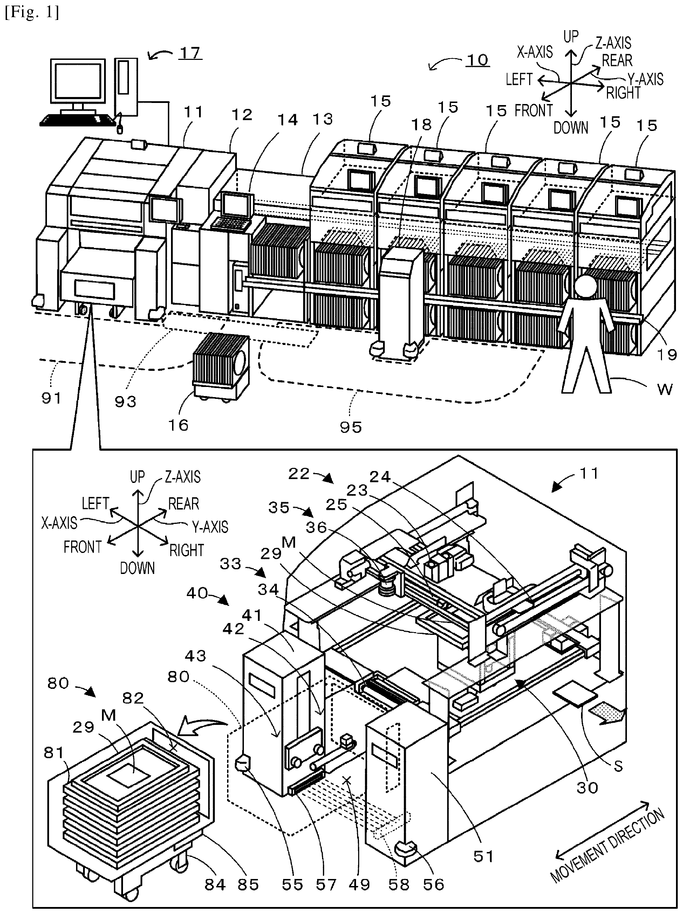

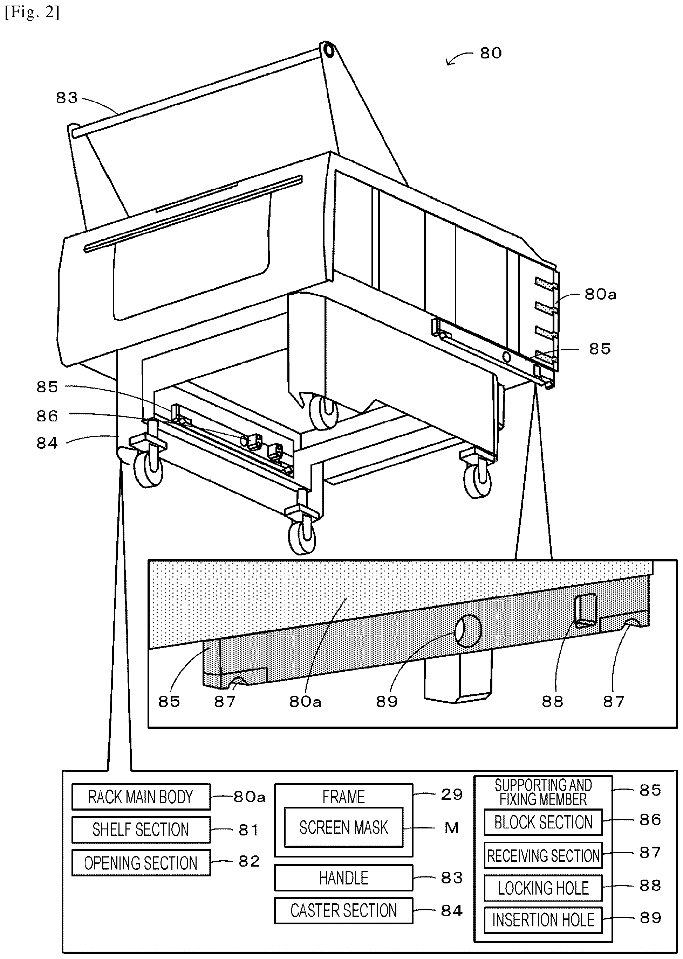

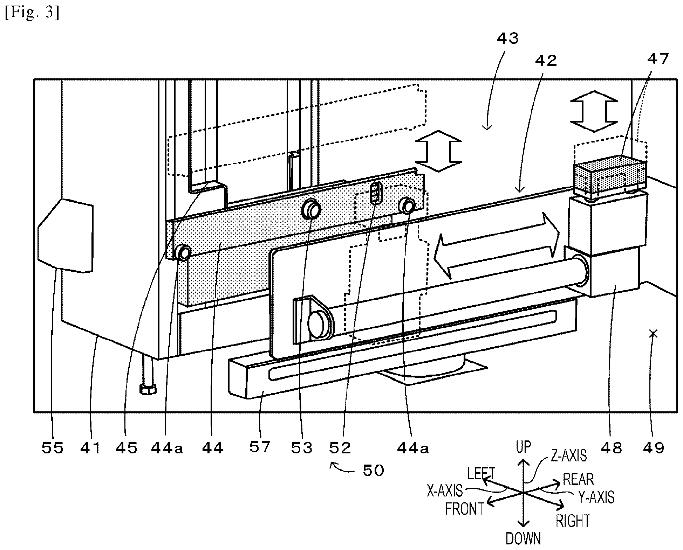

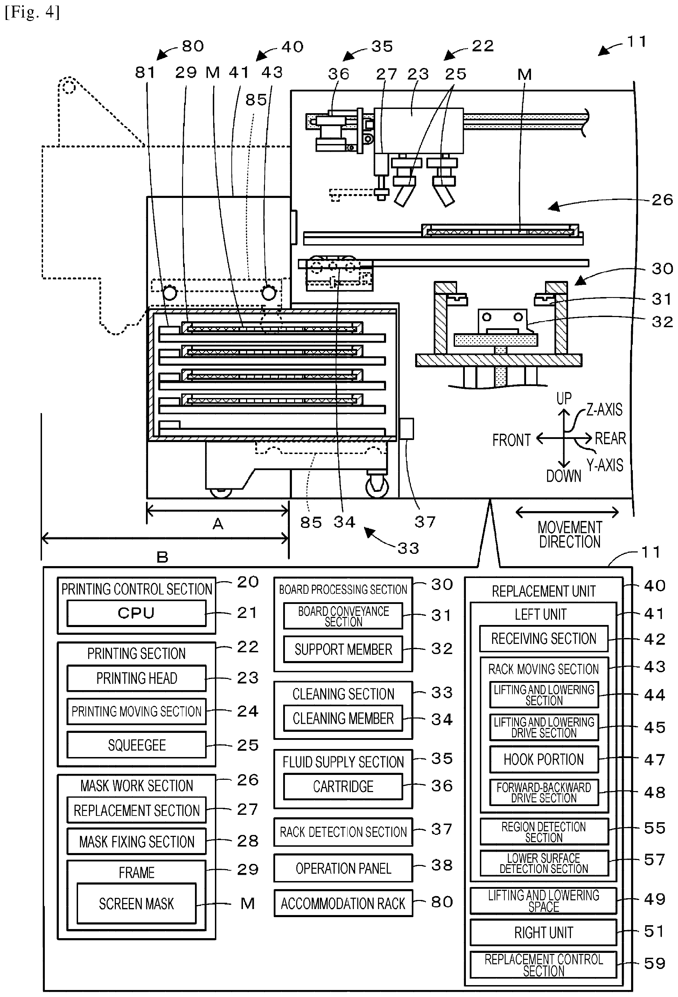

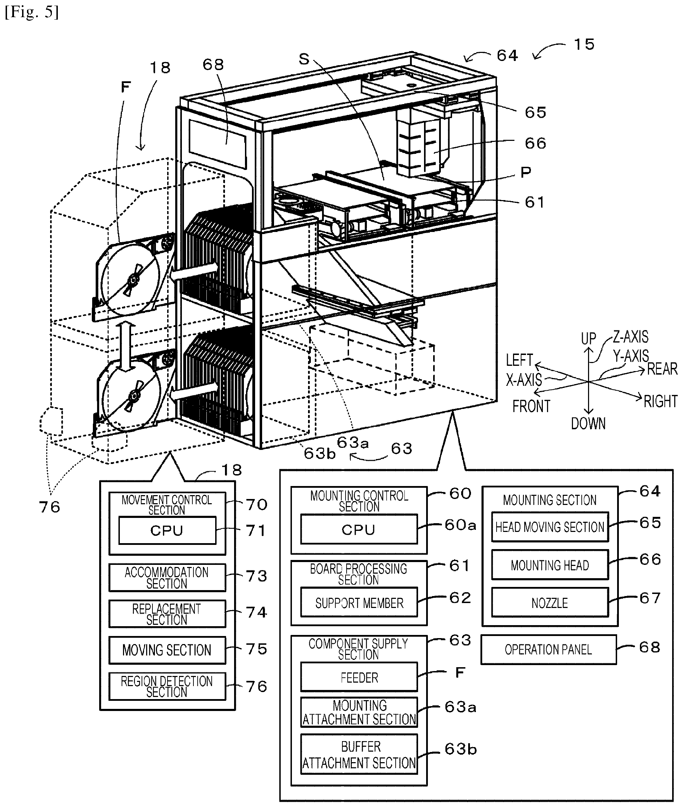

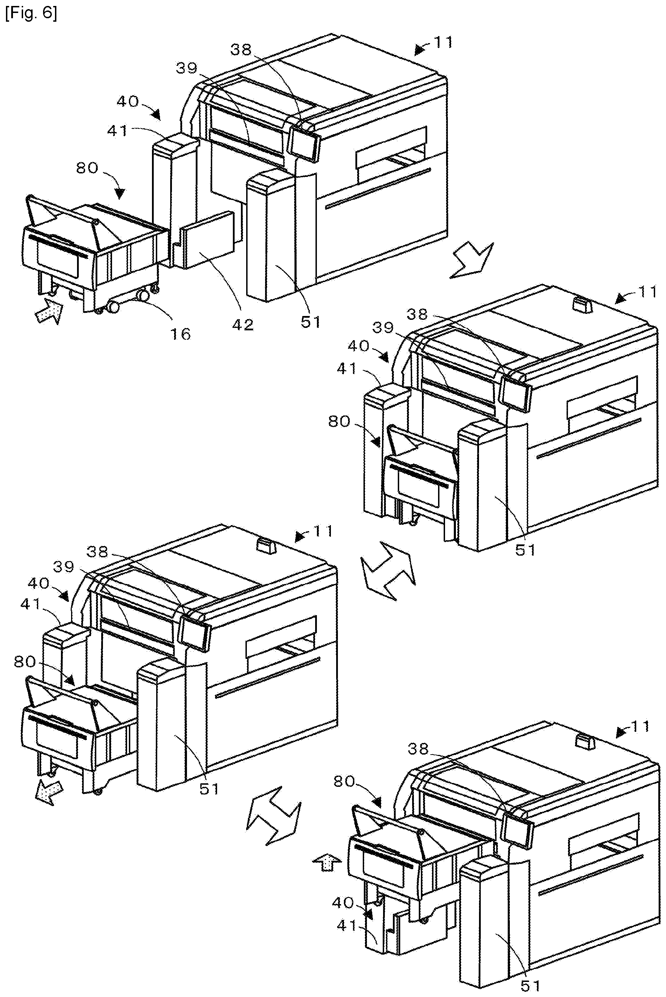

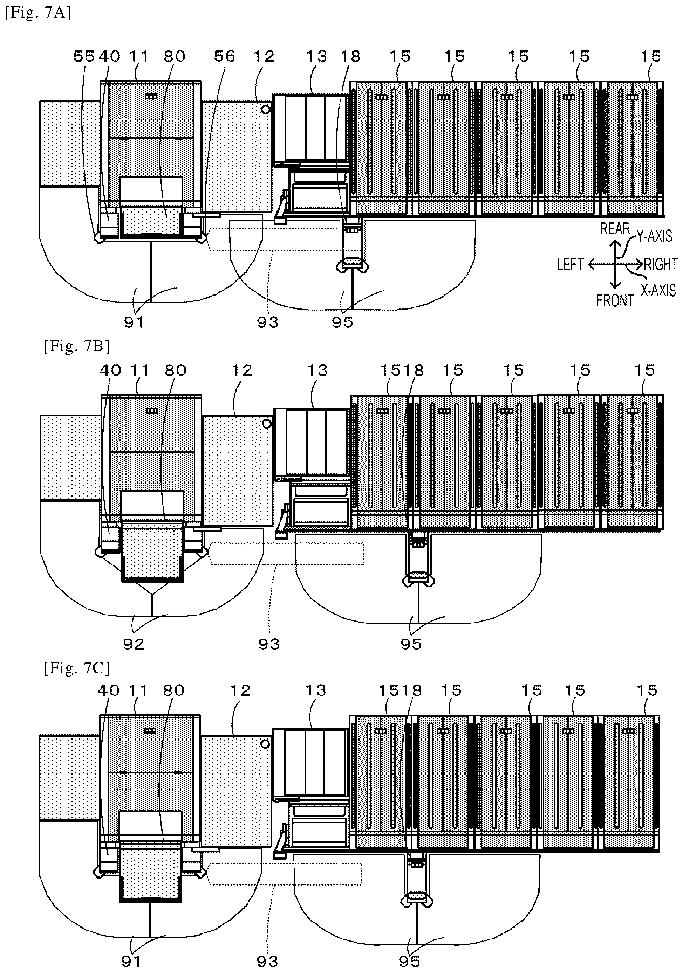

Hereinafter, an embodiment will be described by reference to drawings. Fig. 1 is a schematic explanatory diagram showing an example of mounting system 10 and printing device 11 according to the present disclosure. Fig. 2 is a schematic explanatory diagram of accommodation rack 80. Fig. 3 is an explanatory diagram showing an example of rack moving section 43. Fig. 4 is an explanatory diagram showing an example of printing device 11, replacement unit 40, and accommodation rack 80. Fig. 5 is an explanatory diagram showing an example of mounting device 15 and loader 18. Fig. 6 is an explanatory diagram showing a receipt of accommodation rack 80 and movement thereof between a standby position and a replacement position by receiving section 42. Fig. 7 is an explanatory diagram of first detection region 91, second detection region 92, and waring region 93 of mounting system 10, in which Fig. 7A is an explanatory diagram of first detection region 91 when accommodation rack 80 is in the standby position, Fig. 7B is an explanatory diagram of second detection region 92 when accommodation rack 80 is in a movement region, and Fig. 7C is an explanatory diagram of first detection region 91 when accommodation rack 80 is in the replacement position. This mounting system 10 includes printing device 11, print inspection device 12, storage device 13, host computer (PC) 14, mounting device 15, automatic conveyance vehicle 16, management computer (PC) 17, loader 18, a mounting inspection device, not shown, and a reflow device, not shown. Mounting system 10 is configured as, for example, a production line in which mounting devices 15 for performing a mounting process of mounting component P on board S as a processing target object are aligned in a conveyance direction of board S on a downstream side of printing device 11. In mounting system 10, mounting-related devices which are involved in a mounting process include a conveyance device for conveying board S, printing device 11, print inspection device 12, storage device 13, mounting device 15, loader 18, the mounting inspection device, the reflow device , and the like. Here, in the present embodiment, a left-right direction (an X-axis), a front-rear direction (a Y-axis), and an up-down direction (a Z-axis) are those shown in Figs. 1, 3 to 5, and 7.

Print inspection device 12 constitutes a device for detecting the state of a viscous fluid such as solder paste which is printed on board S by printing device 11. The mounting inspection device constitutes a device for inspecting the state or the like of component P mounted on board S. The reflow device constitutes a device for reflowing a board on which solder is printed and component P is mounted. Management PC 17 constitutes a device for managing information on the individual constituent devices of mounting system 10. This management PC 17 manages the progress status of each of the devices of the production line which are involved in a mounting process.

Printing device 11 constitutes a device for applying (printing) solder as a viscous fluid on to board S as a processing target object which lies therebelow through a pattern hole formed in screen mask M by forcibly pushing solder on screen mask M into the pattern hole using squeegees 25 as shown in Figs. 1 to 4. Here, as the "processing target object", there are raised board S on which component P is mounted, a base material which is a three-dimensional object, and the like. As the "viscous fluid", there are raised solder paste, conductive paste, an adhesive, and the like. Here, the following description will be made on an example in which board S and solder paste are adopted. Screen mask M is fixed in place inside frame 29. Frame 29 can fix therein screen masks M of various sizes and is so sized as to be accommodated in shelf section 81 of accommodation rack 80 (refer to Fig. 1). Printing device 11 includes, as shown in Fig. 4, printing control section 20, printing section 22, mask work section 26, board processing section 30, cleaning section 33, fluid supply section 35, rack detection section 37, operation panel 38, and replacement unit 40.

Printing control section 20 is configured as a microprocessor which mainly includes CPU 21 and controls the whole of printing device 11. Printing control section 20 outputs a signal to management PC 17 as an external device in addition to printing section 22, mask work section 26, board processing section 30, cleaning section 33, fluid supply section 35, operation panel 38, and replacement unit 40. In addition, printing control section 20 receives a signal from management PC 17 as an external device as an input therefrom in addition to printing section 22, mask work section 26, board processing section 30, cleaning section 33, fluid supply section 35, rack detection section 37, operation panel 38, and replacement unit 40. This printing control section 20 has a storage section for storing information on board S on which a printing process is performed, a printing process program for performing a printing process on to board S, a member replacement process program for executing a replacement process of frames 29 by replacement section 27, and the like.

Printing section 22 is disposed at an upper stage of printing device 11, constituting a unit for performing a printing process of printing a viscous fluid on board S using screen mask M. Printing section 22 includes, as shown in Figs. 1 and 4, printing head 23, print moving section 24, a squeegee lifting and lowering section, not shown, and squeegees 25. Print moving section 24 is configured to move printing head 23 in a predetermined printing direction (here, in the front-rear direction) and includes a guide formed in the front-rear direction, a slider configured to move along the guide, and a motor for driving the slider. Squeegees 25 are disposed on a lower surface side of printing head 23 and is lifted and lowered by the squeegee lifting and lowering section. Printing section 22 has two squeegees 25 which are individually used in the front-rear direction. Mask work section 26 is disposed between printing section 22 and board processing section 30 in the up-down direction as shown in Fig. 4, constituting a unit for fixing and holding screen mask M. Mask work section 26 includes replacement section 27 and mask fixing section 28. Replacement section 27 constitutes a conveyance rod provided on printing head 23, and is lowered to a position where replacement section 27 is brought into abutment with screen mask M by means of an air cylinder, not shown, whereby an abutting section configured to be brought into abutment with frame 29 also moves in the front-rear direction by being rotated (refer to dashed lines in Fig. 4). Printing head 23 and replacement section 27 are such as to be brought into engagement with frame 29 so as to move that frame 29 between shelf section 81 at a predetermined height in accommodation rack 80 and printing section 22. Mask fixing section 28 positions screen mask M and supports and fixes screen mask M in a horizontal posture. Screen mask M is pushed to move along the guide of mask work section 26 in the front-rear direction by replacement section 27 and is fixed by mask fixing section 28. Board processing section 30 is disposed below mask work section 26 and constitutes a unit for loading board S, positioning and supporting loaded board S, and moving that board S towards screen mask M for contact therewith and away therefrom. Board processing section 30 includes board conveyance section 31 for conveying board S in the left-right direction, support member 32 for supporting board S from below, and a board lifting and lowering section for lifting and lowering the whole of board processing section 30 and support member 32. Cleaning section 33 is disposed between mask work section 26 and board processing section 30 in the up-down direction, constituting a unit for executing a cleaning process of cleaning a rear surface of screen mask M. Cleaning section 33 has cleaning member 34, whereby screen mask M is cleaned as a result of cleaning member 34 being brought into abutment therewith. Fluid supply section 35 constitutes a unit for supplying solder accommodated in cartridge 36 on to screen mask M. Fluid supply section 35 is disposed ahead of printing head 23. Fluid supply section 35 applies a pressure to cartridge 36 so as to discharge solder from cartridge 36. Cleaning member 34 and cartridge 36 are consumables and are replaced as required. Rack detection section 37 constitutes a sensor for detecting whether accommodation rack 80 exists in a front interior portion of printing device 11. Operation panel 38 constitutes a unit for receiving an input from operator W and presenting information to operator W. This operation panel 38 includes a display section, which is a display, and an operation section of a touch panel type having a button.

Accommodation rack 80 constitutes an accommodation body for accommodating frames 29 configured to support screen mask M as a printing-related member involved in a printing process performed in printing section 22. Accommodation rack 80 has, as shown in Figs. 1, 2, rack main body 80a, handle 83, caster section 84, and supporting and fixing member 85. Rack main body 80a has multiple shelf sections 81 and one opening section 82. Shelf sections 81 are disposed in such a manner as to be aligned at predetermined intervals in the up-down direction so that frames 29 supporting screen mask M can be placed in the up-down direction. Opening section 82 communicates with an outside such as printing section 22, and frame 29 is loaded and unloaded through this opening section 82. This accommodation rack 80 only accommodates frames 29 and includes no drive source such as a drive section for moving frame 29 and a drive section for lifting and lowering frame 29. With this accommodation rack 80, the configuration can be simplified more. Shelf section 81 has a size which can deal with frame sizes for various types of printing-related members. That is, shelf section 81 is so sized as to accommodate largest frame 29. This accommodation rack 80 may be configured to have shelf sections 81 which individually deal with frame sizes for various types of printing-related members, or one accommodation rack 80 may be configured to have multiple shelf sections 81 of the same size. In the latter case, multiple accommodation racks 80 having the same external size may be prepared, so that shelf sections 81 of each accommodation rack 80 deal with or correspond to any one of frame sizes for various types of printing-related members. In this case, although the number of types of accommodation racks 80 is increased, even though frame sizes of corresponding printing-related members differ, since the external sizes of accommodation racks 80 are the same, those accommodation racks 80 can individually share receiving section 42. Handle 83 is fixed to an upper part of rack main body 80a. Handle 83 includes a rod-shaped body configured to be gripped by operator W and a support member which fixes the rod-shaped body. Caster section 84 is disposed at a lower portion of rack main body 80a. This caster section 84 includes a structure having a space in the center thereof and a caster having a wheel disposed on a lower surface side of the structure. Operator W can move accommodation rack 80 by holding this handle 83. Here, as printing-related members, there are raised, for example, squeegee 25, support member 32, cleaning member 34, cartridge 36, in addition to screen mask M.

Supporting and fixing member 85 is a plate-shaped member and is fixed to left and right end portions at a front of a lower surface of rack main body 80a. This supporting and fixing member 85 is a member which is used for connection to replacement unit 40. As shown in Fig. 2, supporting and fixing member 85 has block section 86, receiving sections 87, locking hole 88, and insertion hole 89. Block section 86 is a member to which hook portion 47 that replacement unit 40 includes is connected and has a space between two blocks to which hook portion 47 is inserted. Receiving section 87 is a section for receipt of cam follower 44a disposed on lifting and lowering member 44 of replacement unit 40 and has an arc-shaped notch. Locking hole 88 is a through hole into which clamp lever 52 of fixing section 50 disposed on lifting and lowering member 44 of replacement unit 40 is inserted. Insertion hole 89 is a through hole into which insertion pin 53 of fixing section 50 disposed on lifting and lowering member 44 of replacement unit 40 is inserted.

Replacement unit 40 is a unit configured to be used in printing device 11 including printing section 22 for executing a printing process of printing a viscous fluid on a processing target object using screen mask M so as to automatically replace printing-related members for use in printing device 11 between printing device 11 and itself. Replacement unit 40 is configured as a device for receiving accommodation rack 80 which accommodates printing-related members such as screen masks M which are fixed to corresponding frames 29 so as to lift and lower accommodation rack 80. Replacement unit 40 has left unit 41 and right unit 51. Left unit 41 is disposed at a front left-hand side of a housing of printing device 11. Right unit 51 is disposed at a front right-hand side of the housing of printing device 11. As shown in Fig. 4, these left unit 41 and right unit 51 are formed such that length A along a movement direction of frame 29 is shorter than length B of accommodation rack 80. This replacement unit 40 has lifting and lowering space 49 defined in a center between left unit 41 and right unit 51 for lifting and lowering accommodation rack 80. This replacement unit 40 accommodates accommodation rack 80 in the same surface as a front surface of a main body of this replacement unit 40 or further inwards than the front surface of this main body when accommodation rack 80 stays in a standby position, whereas when accommodation rack 80 stays in a replacement position, this replacement unit 40 supports accommodation rack 80 in a position which projects further than the front surface of the main body of this replacement unit 40. Here, understanding that right unit 51 has the same configuration as that of left unit 41 except that right unit 51 faces left unit 41, a detailed description thereof will be omitted. Here, right unit 51 includes region detection section 56, lower surface detection section 58, and the like in addition to a receiving section, a rack moving section, a lifting and lowering member, a cam follower, a lifting and lowering drive section, a forward-backward moving section, a hook portion, a forward-backward drive section, and a fixing section.

Left unit 41 includes receiving section 42, rack moving section 43, fixing section 50, region detection section 55, and lower surface detection section 57. Receiving section 42 is configured to receive accommodation rack 80 having multiple shelf sections 81 accommodating frame 29 which can support a printing-related member for use in printing device 11 and supports this accommodation rack 80 from a lower surface side thereof so as to lift and lower this accommodation rack 80. Rack moving section 43 is configured to lift and lower, and move forwards and backwards accommodation rack 80 among the replacement position where printing-related members are replaced, a lifting enabling position which lies further downwards than this replacement position, and the standby position where accommodation rack 80 enters an inside of the housing of printing device 11. In replacement unit 40, a region defined between the replacement position and the standby position excluding the replacement position and the standby position is referred to as a "movement region" of accommodation rack 80. Rack moving section 43 includes, as shown in Fig. 3, lifting and lowering member 44, lifting and lowering drive section 45, hook portion 47, and forward-backward drive section 48. Lifting and lowering member 44 is a plate-like member provided on a surface of left unit 41 which faces right unit 51. This lifting and lowering member 44 is caused to move up and down along an inner surface of a housing of left unit 41 by lifting and lowering drive section 45. Cam follower 44a is disposed at front and rear end portions of lifting and lowering member 44. Cam followers 44a support supporting and fixing member 85 disposed on accommodation rack 80 from therebelow to thereby move up and down accommodation rack 80 as lifting and lowering member 44 moves up and down. Lifting and lowering drive section 45 may be configured to have, for example, a ball screw having a lifting and lowering shaft and a drive motor so as to move up and down lifting and lowering member 44 or may be configured to move up and down lifting and lowering member 44 by a linear motor. In addition, this rack moving section 43 has fixing section 50 configured to restrict accommodation rack 80 from moving in a horizontal direction and/or falling when accommodation rack 80 moves to the lifting enabling position to enter a state in which accommodation rack 80 can be lifted and lowered. Fixing section 50 constitutes a safety mechanism for preventing an unintended movement or fall of accommodation rack 80 when accommodation rack 80 is lifted and lowered by rack moving section 43. Fixing section 50 includes a clamp section having clamp lever 52 configured to be inserted into locking hole 88 formed in supporting and fixing member 85, a stopper section having insertion pin 53 configured to be inserted into insertion hole 89 formed in supporting and fixing member 85, and the like. Hook portion 47 is disposed on a shaft of forward-backward drive section 48 in such a manner as to be lifted and lowered and constitutes a member configured to be lifted up towards block section 86 provided on accommodation rack 80 for engagement with this block section 86. Forward-backward drive section 48 is configured to move hook portion 47 between a standby position and a lifting enabling position. Forward-backward drive section 48 may be configured to have a ball screw and a drive motor so as to move hook portion 47 forwards and backwards or may be configured to move hook portion 47 forwards and backwards by a linear motor.

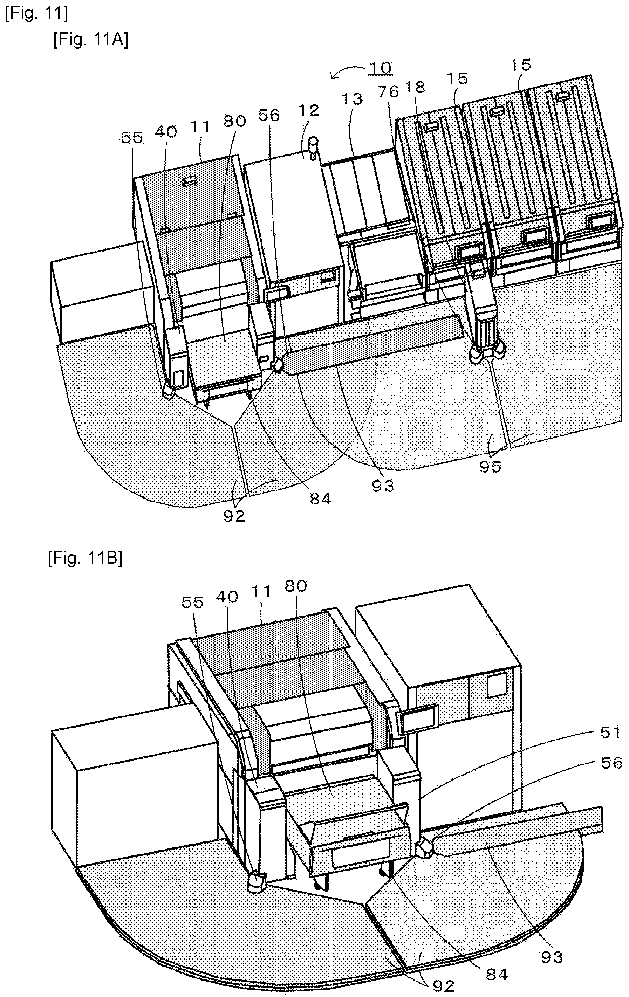

Region detection section 55 is a sensor for detecting an object existing on a circumference of left unit 41. This region detection section 55 can use, for example, a laser scanner, an infrared sensor, or the like and can detect an object by switching multiple different detection regions. Region detection section 55 covers a range of 270° around or centered at a sensor thereof excluding a region of the housing of left unit 41, which is referred to as first detection region 91 (refer to Figs. 7A and 7C), and a range of 225° resulting from cutting out a range of 45° in front of a front surface of the housing of left unit 41, which is referred to as second detection region 92 (refer to Fig. 7B), and detects an object existing inside these regions. First detection region 91 can be, for example, a region including a front surface, particularly the whole of a front surface of replacement unit 40. In addition, second detection region 92 can be, for example, a region narrower than first detection region 91, and is a region avoiding a member disposed on accommodation rack 80, for example, caster section 84 (refer to Fig. 11, which will be described later). Second detection region 92 is set as a region having a triangular blank region in front of a front surface of printing device 11. Region detection section 55 detects an object existing in a region ranging from the front surface to a left-hand side of printing device 11. Region detection section 56 is a sensor for detecting an object existing on a circumference of right unit 51. This region detection section 56 has the same configuration as that of region detection section 55 and covers a range of 270° excluding a region of a housing of right unit 51, which is referred to as first detection region 91 (refer to Figs. 7A, 7C), and a range of 225° resulting from cutting out a range of 45° in front of a front surface of the housing of right unit 51, which is referred to as second detection region 92 (refer to Fig. 7B), and detects an object existing inside these regions. In addition, region detection section 56 covers a region on a side thereof, for example, a rectangular region in front of print inspection device 12 as warning region 93 and has a function to detect an object existing in this warning region 93. As shown in Figs. 1, 7, warning region 93 is a region overlapping a movement region of loader 18 and can be a region which can detect an approach of loader 18. In addition, warning region 93 includes regions outside first detection region 91 and second detection region 92. When defining a time assumed to be taken for accommodation rack 80 to move from a position outside detection region 95 to a position inside detection region 95 as a rack movement time and defining a time assumed to be taken for detection region 95 to move together with loader 18 from a position outside warning region 93 to a position including the movement region as a loader movement time, a distance of this warning region 93 from region detection section 56 in a movement direction of loader 18 is determined so that the rack movement time becomes shorter than the loader movement time. By providing this warning region 93, replacement unit 40 can detect an approach of loader 18 before loader 18 enters first detection region 91 or second detection region 92. Lower surface detection section 57 is an area sensor which is used together with lower surface detection section 58 disposed at a lower portion of right unit 51 as a pair as shown in Figs. 1, 3. These lower surface detection sections 57, 58 are configured as a light curtain having either or both of multiple irradiation sections arranged in a straight line and multiple light receiving sections arranged in a straight line and configured to detect an existence of an object as a result of light being interrupted. Region detection sections 55, 56 and lower surface detection sections 57, 58 are sensors used to secure the safety of operator W or the like by restricting the movement of accommodation rack 80 when moving accommodation rack 80 between the standby position and the replacement position.

Replacement unit 40 has replacement control section 59. Replacement control section 59 is configured as a microprocessor which mainly includes CPU and controls the whole of replacement unit 40. Replacement control section 59 outputs a signal to printing control section 20 in addition to lifting and lowering drive section 45, and forward-backward drive section 48. In addition, replacement control section 59 receives a signal as an input from printing control section 20 in addition to region detection sections 55, 56 and lower surface detection sections 57, 58. Upon receipt of a signal informing that accommodation rack 80 is received in receiving section 42 from rack detection section 37, this replacement control section 59 performs a process of lifting up hook portion 47 so as to bring this hook portion 47 into engagement with block section 86. In addition, to replace printing-related members, replacement control section 59 performs a process of causing rack moving section 43 to lift up accommodation rack 80 from the standby position to the replacement position via the lifting enabling position. In addition, when the replacement of printing-related members is completed, replacement control section 59 causes rack moving section 43 to move accommodation rack 80 from the replacement position to the standby position via the lifting enabling position.

Mounting device 15 constitutes a device for picking up component P to mount it on board S as a processing target object. This mounting device 15 includes, as shown in Fig. 5, mounting control section 60, board processing section 61, component supply section 63, and mounting section 64. Mounting control section 60 is configured as a microprocessor which mainly includes CPU 60a and governs the control of the whole of the device. Mounting control section 60 has a storage section which stores mounting condition information (a production job) including information on components P and information on an arrangement order in which components P are mounted on board S, arrangement positions, a mounting position of feeder F from which components P are picked up, and the like. Mounting control section 60 outputs control signals to board processing section 61, component supply section 63, mounting section 64, and operation panel 68 while receiving signals as inputs from board processing section 61, component supply section 63, mounting section 64, and operation panel 68. Board processing section 61 performs a series of processes of loading, conveying, fixing in a mounting position, and unloading board S, as well as a process of supporting board S from therebelow using support member 62. Support member 62 includes a backup plate constituting a base, a backup pin which is disposed in an arbitrary position depending on board S, and the like. This backup pin may be configured to be disposed in a predetermined position on the backup plate by mounting section 64. Component supply section 63 constitutes a unit for supplying component P to mounting section 64. This component supply section 63 attaches feeder F including a reel around which a tape as a holding member which holds components P is wound to one or more mounting sections. This component supply section 63 includes mounting attachment section 63a to which feeders F for use for a mounting process are attached and buffer attachment section 63b to which spare feeders F are attached in upper and lower stages. Here, mounting attachment section 63a and buffer attachment section 63b are collectively referred to as an attachment section. Feeder F includes a controller, not shown. This controller stores information on ID of a tape and a type of component P, as well as the number of components P remaining in feeder F. Upon attachment of feeder F to the attachment section, this controller transmits information on feeder F to mounting control section 60. In addition, component supply section 63 may include a tray unit having a tray as a holding member on which multiple components P are placed while being arranged as required.

Mounting section 64 constitutes a unit for picking up component P from component supply section 63 to dispose it on board S fixed in board processing section 61. Mounting section 64 includes head moving section 65, mounting head 66, and nozzle 67. Head moving section 65 includes a slider configured to move in XY directions by being guided by a guide rail and a motor for driving the slider. Mounting head 66 is configured to pick up one or more components P and to be moved in the XY directions by head moving section 65. This mounting head 66 is detachably attached to the slider. One or more nozzles 67 are detachably attached to a lower surface of mounting head 66. Nozzle 67 is configured to pick up component P by making use of a negative pressure. Here, a pickup member for picking up component P may adopt a mechanical chuck for mechanically holding component P or the like in addition to nozzle 67. Operation panel 68 constitutes a unit for not only receiving inputs from operator W but also presenting information to operator W. This operation panel 68 includes a display section which is a display and an operation section of a touch panel type having a button.

As shown in Fig. 1, storage device 13 constitutes a storing place for storing temporarily feeders F as mounting-related members for use in mounting device 15. Storage device 13 has a conveyance device for conveying board S and is provided between print inspection device 12 and mounting device 15. Storage device 13 has an attachment section similar to that of component supply section 63. When feeder F is connected to this attachment section, a controller of feeder F outputs information on feeder F to host PC 14 connected to storage device 13. In storage device 13, while feeder F is conveyed by automatic conveyance vehicle 16, feeder F may be conveyed by operator W. Host PC 14 is configured as a device for managing work details and operation results of storage device 13 and loader 18. Automatic conveyance vehicle 16 conveys members for use in mounting system 10, for example, printing-related members for use in replacement unit 40, and conveys mounting-related members for use in loader 18. This automatic conveyance vehicle 16 automatically conveys, for example, printing-related members and mounting-related members between a warehouse, not shown, and storage device 13. This automatic conveyance vehicle 16 may be an automatic guided vehicle (AGV) configured to move along a predetermined traveling path or may be an autonomous mobile robot (AMR) configured to move along a free route by detecting therearound. Here, for moving accommodation rack 80, automatic conveyance vehicle 16 may be configured to move accommodation rack 80 by, for example, causing a loading section, not shown, disposed on an upper surface thereof to be lifted in such a state that automatic conveyance vehicle 16 enters a space defined in the center of caster section 84.

Loader 18 is configured as a mobile work device and constitutes a device configured to move within a moving range existing on a circumference of mounting device 15 on a front surface side of mounting device 15 to automatically attach, detach, collect, and feed mounting-related members such as feeders F for use in mounting device 15. This loader 18 includes, as shown in Fig. 5, movement control section 70, accommodation section 73, replacement section 74, moving section 75, and region detection section 76. Movement control section 70 is configured as a microprocessor which mainly includes CPU 71 and governs the control of the whole of the device. This movement control section 70 controls the whole of the device to cause the device to move feeder F between storage device 13 and the device so as to collect feeder F from component supply section 63 or feed feeder F to component supply section 63. Accommodation section 73 has an accommodation space for accommodating one or more feeders F. This accommodation section 73 is configured to accommodate, for example, four feeders F. Replacement section 74 constitutes a mechanism for loading and unloading feeder F in and from accommodation section 73, as well as moving feeder F to the lower and upper stages. Replacement section 74 has a clamp section for clamping feeder F, a Y-axis slider for moving the clamp section in a Y-axis direction (front-rear direction), and a Z-axis slider for moving the clamp section in a Z-axis direction (up-down direction). Replacement section 74 attaches and detaches feeder F to and from mounting attachment section 63a, attaches and detaches feeder F to and from buffer attachment section 63b, and attaches and detaches feeder F to and from the attachment section of storage device 13. Moving section 75 constitutes a mechanism for moving loader 18 in an X-axis direction (left-right direction) along X-axis rail 19 disposed on front surfaces of mounting devices 15. Region detection section 76 constitutes a sensor for detecting whether an object exists on a circumference of a main body of loader 18. Region detection section 76 detects an existence of an object in detection region 95 which includes the circumference of loader 18 on a front surface side of mounting system 10. Region detection section 76 can adopt a laser scanner as with region detection section 55. This region detection section 76 is the sensor used to secure the safety of operator W by restricting the movement of loader 18 when it is moved. Loader 18 outputs a current position thereof and details of executed work to host PC 14. This loader 18 automatically attaches and detaches feeders F as mounting-related members; however, in addition to this, loader 18 may be configured to collect and feed members involved in a mounting process such as support member 62, mounting head 66, nozzle 67, and the like.

In this mounting system 10, printing device 11 and mounting devices 15 are disposed in such a manner that their front surfaces are on the same side, and replacement unit 40 and loader 18 as a moving work device are disposed on the same side. In particular, in mounting system 10, replacement unit 40 and loader 18 are disposed on the front surface sides of printing device 11 and mounting devices 15. In this mounting system 10, storage device 13 is disposed between printing device 11 and mounting device 15 in such a manner that a replacement work position is situated on the same side as the side where replacement unit 40 and loader 18 are disposed. In addition, in this mounting system 10, as shown in Fig. 1, automatic conveyance vehicle 16 has the traveling path on the side where replacement unit 40 and loader 18 are disposed. Loader 18 replaces feeders F as mounting-related members between storage device 13 and mounting device 15.

Next, a printing process of printing device 11 configured in the way described heretofore will briefly be described. In execution of a printing process, automatic conveyance vehicle 16 performs an operation of conveying accommodation rack 80 to replacement unit 40 (a topmost diagram in Fig. 6) and causing replacement unit 40 to receive accommodation rack 80 (a second topmost diagram in Fig. 6). After replacement unit 40 receives accommodation rack 80 conveyed thereto by automatic conveyance vehicle 16, operator W inputs an execution command of the printing process from operation panel 38. A printing process routine for executing the printing process is stored in a storage section of printing control section 20 and is executed by CPU 21 of printing control section 20 after the execution command of the printing process has been inputted by operator W. When the printing process routine is started, CPU 21 first performs a process of bringing board S into abutment with screen mask M by causing board processing section 30 to convey, fix, and lift board S. For this, CPU 21 causes mask work section 26 to adjust the position of screen mask M to thereby perform a position alignment between a pattern hole and board S. Subsequently, CPU 21 causes cartridge 36 to move above screen mask M to discharge solder thereon. Subsequently, CPU causes squeegees 25 to be lowered while causing printing head 23 to move, so that squeegees 25 are brought into abutment with an upper surface of screen mask M while being caused to move in the front-rear direction so as to print the solder on board S. In this way, printing control section 20 performs the printing process including the board conveyance and fixation process, the solder supply process, and the squeegee moving process to execute the printing on board S. In addition, when the use of current screen mask M is completed, CPU 21 executes a process of replacing this current screen mask M with subsequent screen mask M. First, CPU 21 pulls out accommodation rack 80 from the standby position where accommodation rack 80 is pulled into the housing of printing device 11 to the lifting enabling position (a third topmost diagram in Fig. 6) and lifts up accommodation rack 80 to the replacement position (a fourth topmost in Fig. 6). Then, CPU 21 causes replacement section 27 to replace screen masks M and causes rack moving section 43 to move accommodation rack 80 to the standby position when the replacement is completed. CPU 21 repeatedly performs the printing process while replacing screen masks M until the production process of all the types of boards S in the production plan is completed.

Subsequently, a process will briefly be described in which mounting device 15 mounts component P on board S. When a mounting process is started, CPU 60a of mounting control section 60 first causes board processing section 61 to load and fix board S. Subsequently, CPU 60a performs a process of reading out the mounting condition information, and causing mounting head 66 to pick up component P from feeder F attached to component supply section 63 and to dispose it on board S based on this mounting condition information. When the disposition of component P on board S is completed, CPU 60a causes board processing section 61 to discharge board S and repeats this process described above. CPU 60a manages the number of components consumed in each feeder F during the mounting process, and when the number of remaining components becomes equal to or smaller than a predetermined warning value, CPU 60a transmits information to that effect to host PC 14. Host PC 14 causes loader 18 to execute a replacement operation based on this information. Loader 18 moves between storage device 13 and mounting device 15 along X-axis rail 19 and executes a replacement process of feeders F in work target mounting device 15. In this way, mounting device 15 repeatedly performs the process of disposing component P on board S while replacing feeders F until the production process of all boards S in the production plan is completed.

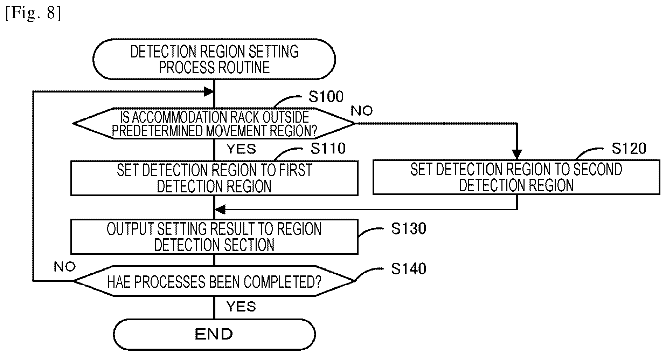

Next, a specific process of securing safety in replacing printing-related members by moving accommodation rack 80 in replacement unit 40 will be described. Firstly, here, setting of first detection region 91 and second detection region 92 will be described. Fig. 8 is a flowchart showing an example of a detection region setting process routine which is executed by replacement control section 59. This routine is stored in a storage section of replacement control section 59 and is executed after the printing process is started by printing device 11. When this routine is executed, CPU of replacement control section 59 determines whether accommodation rack 80 exists outside a predetermined movement region (S100). The movement region is set to a region where accommodation rack 80 moves between the standby position and the replacement position excluding the standby position and the replacement position. When accommodation rack 80 exists outside the movement region, that is, when accommodation rack 80 exists in the standby position or the replacement position, a detection region for detecting an existence of an object is set to first detection region 91 (S110). When accommodation rack 80 exists outside the movement region, replacement control section 59 detects an existence of an object using first detection region 91 which constitutes a wider detection region because there is no risk of a member disposed on accommodation rack 80, for example, caster section 84 or the like being erroneously detected. On the other hand, when accommodation rack 80 exists inside the movement region in S100, the detection region where to detect an existence of an object is set to second detection region 92 (S120). When accommodation rack 80 exists inside the movement region, replacement control section 59 detects an existence of an object using second detection region 92 which constitutes a narrower detection region because there is a risk of a member disposed on accommodation rack 80, for example, caster section 84 or the like being erroneously detected. After S120 or after S110, CPU outputs the result of the setting to region detection sections 55, 56 (S130). Region detection sections 55, 56 execute a detection of an object using the detection area which is the result of the setting. Then, CPU determines whether all the processes have been completed (S140), and executes the processes from S100 onward when all the processes have not yet been completed. On the other hand, when it is determined in S140 that all the processes have been completed, for example, when the printing process has been completed or when a power supply is switched off, CPU ends this routine. In this way, with replacement unit 40, the detection regions of region detection sections 55, 56 are changed in accordance with the position of accommodation rack 80.

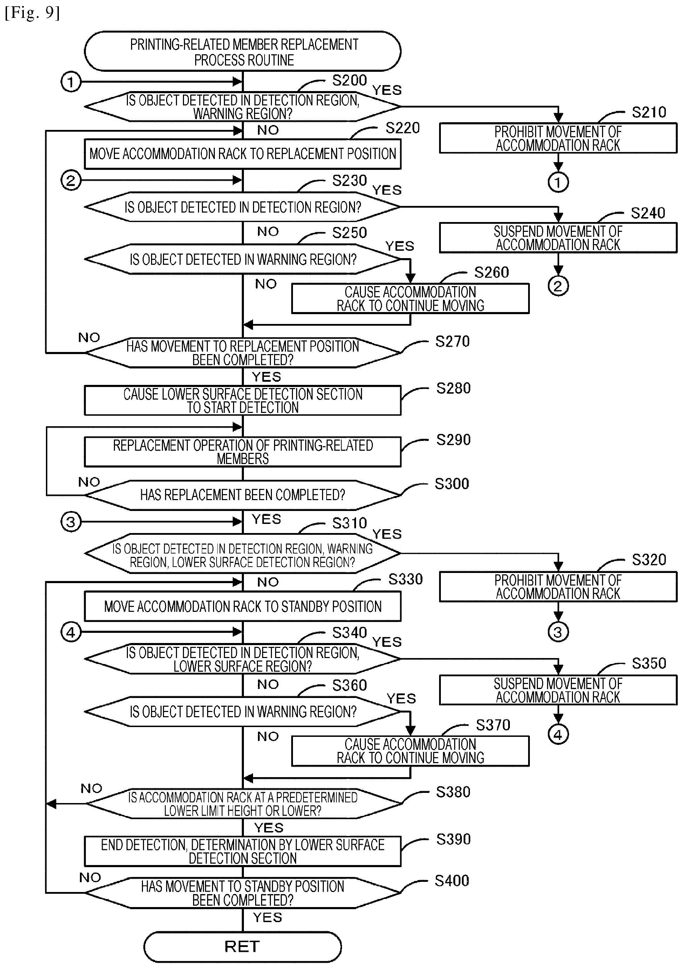

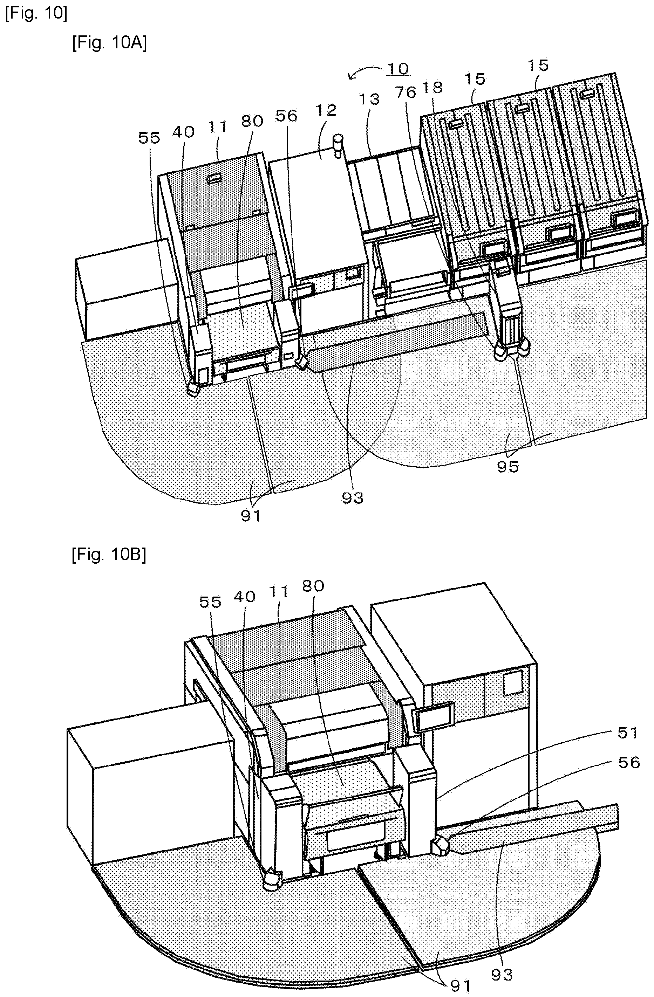

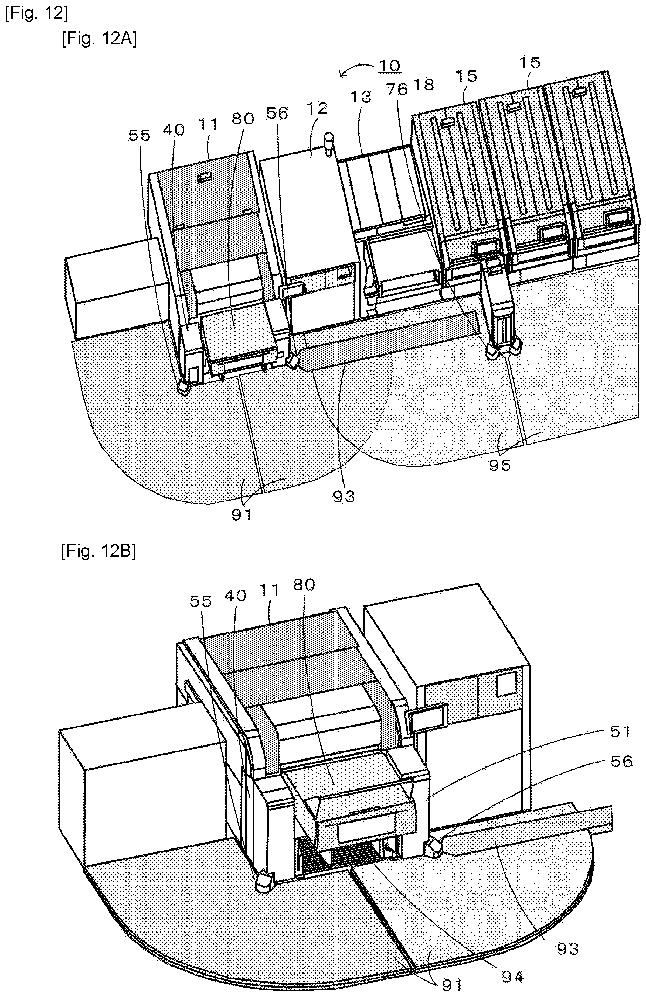

Next, a specific process of replacing printing-related members by moving accommodation rack 80 will be described. Fig. 9 is a flowchart showing an example of a printing-related member replacement process routine which is executed by replacement control section 59. This routine is stored in the storage section of replacement control section 59, and is executed when a timing is reached when screen masks M as printing-related members are replaced. It is understood that in starting this routine, accommodation rack 80 exists in the standby position and the detection region is set to first detection region 91. Further, Fig. 10 is an explanatory diagram of first detection region 91 when accommodation rack 80 is in the standby position, in which Fig. 10A is a diagram showing first detection region 91, warning region 93, and detection region 95, and Fig. 10B is a perspective view of a circumference of printing device 11. Fig. 11 is an explanatory diagram of second detection region 92 when accommodation rack 80 is in the movement region, in which Fig. 11A is a diagram showing second detection region 92, warning region 93, and detection region 95, and Fig. 11B is a perspective view of the circumference of printing device 11. Fig. 12 is an explanatory diagram of first detection region 91 and lower surface region 94 when accommodation rack 80 is in the replacement position, in which Fig. 12A is a diagram showing first detection region 91, warning region 93, and detection region 95, and Fig. 12B is a perspective view of the circumference of printing device 11.

When this routine is executed, CPU of replacement control section 59 not only determines whether an object is detected in the detection region but also determines whether an object is detected in warning region 93 (S200). CPU executes these determinations by obtaining detection signals in first detection region 91 from region detection sections 55, 56 (refer to Fig. 10). When an existence of an object is detected in at least one of first detection region 91 and warning region 93, CPU prohibits the movement of accommodation rack 80 (S210) and executes the processes from S200 onward. That is, CPU does not execute the movement of accommodation rack 80 until an object is detected in neither the detection region nor warning region 93. On the other hand, when an object is detected in neither the detection region nor warning region 93, CPU executes a process of causing accommodation rack 80 to move to the replacement position (S220). At this time, the detection region is switched from first detection region 91 to second detection region 92 (refer to Fig. 11).

After S220, CPU of replacement control section 59 determines whether an object is detected in the detection region based on signals obtained from region detection sections 55, 56 (S230), and when an object is detected in the detection region, CPU suspends the movement of accommodation rack 80 (S240), and executes the processes from S230 onward. Here, CPU may also be configured to determine whether an object is detected in second detection region 92 and suspend the movement of accommodation rack 80, for example, for a predetermined period of time (3 seconds, 5 seconds, 10 seconds, or the like) as a temporary stop. On the other hand, when an object is not detected in the detection region in S230, CPU determines whether an object has been detected in warning region 93 (S250), and when an object is detected in warning region 93, CPU causes accommodation rack 80 to continue moving (S260). An object to be detected in warning region 93 is mainly loader 18, whereby replacement control section 59 can detect an approach of loader 18. Although details will be described later, loader 18 temporarily stops its movement along X-axis rail 19 upon detection of an object in detection region 95. Since there may be a case in which, for example, caster section 84 enters detection region 95 while accommodation rack 80 stays inside the movement region, replacement control section 59 causes accommodation rack 80 to continue moving so that accommodation rack 80 moves out of detection region 95 without any delay.

After S260, or when no object is detected in warning region 93 in S250, CPU of replacement control section 59 determines whether accommodation rack 80 has completed the movement to the replacement position (S270). When accommodation rack 80 has not completed the movement to the replacement position, CPU executes the processes from S220 onward. That is, after accommodation rack 80 has started moving, CPU executes the movement of accommodation rack 80 when no object is detected in second detection region 92, and causes accommodation rack 80 to continue moving even though an object is detected in warning region 93.

On the other hand, when accommodation rack 80 has completed the movement to the replacement position in S270, CPU of replacement control section 59 activates lower surface detection sections 57, 58, causing them to start detection (S280) for execution of a replacement process of screen masks M as printing-related members (S290). For this, the detection region is switched from second detection region 92 to first detection region 91 (refer to Fig. 12). In addition, lower surface detection sections 57, 58 execute a detection of an object in lower surface region 94 which exists on a lower surface side of accommodation rack 80. In the replacement process, for example, replacement control section 59 causes lifting and lowering drive section 45 to lift up vacant shelf section 81 to the height of the replacement position in printing device 11, outputs a replacement command to printing device 11, and causes printing control section 20 which receives the output to drive replacement section 27 to move frame 29 for discharge. Subsequently, replacement control section 59 causes lifting and lowering drive section 45 to lift up shelf section 81 on which screen mask M for subsequent use is placed to the height of the replacement position, outputs a replacement command to printing device 11, and causes printing control section 20 which receives the output to drive replacement section 27 to move frame 29 for introduction. Subsequently, CPU determines whether the replacement process has completed (S300), and when the replacement process has not yet been completed, CPU executes the processes from S290 onward.

On the other hand, when the replacement process is determined to have been completed in S300, CPU of replacement control section 59 determines whether an object is detected in the detection region, whether an object is detected in warning region 93, and whether an object is detected in lower surface region 94 (S310). CPU executes this determination by obtaining detection signals in first detection region 91 from region detection sections 55, 56, a detection signal in warning region 93 from region detection section 56, and detection signals in lower surface region 94 from lower surface detection sections 57, 58 (refer to Fig. 12). When an object is detected in any one or more areas in the areas, CPU prohibits the movement of accommodation rack 80 (S320) and executes the processes from S310 onward. That is, CPU does not execute the movement of accommodation rack 80 until no object is detected in all of the detection region, warning region 93 and lower surface region 94. On the other hand, when no object is detected in any of the detection region, warning region 93, and lower surface region 94 in S310, CPU executes a process of moving accommodation rack 80 to the standby position (S330). At this time, the detection region is switched from first detection region 91 to second detection region 92 (refer to Fig. 11).

After S330, CPU of replacement control section 59 determines whether an object is detected in either of the detection region and lower surface region 94 (S340). CPU executes this determination based on detection signals in second detection region 92 obtained from region detection sections 55, 56, and detection signals in lower surface region 94 obtained from lower surface detection sections 57, 58. When an object is detected in either of the detection region and lower surface region 94, CPU suspends the movement of accommodation rack 80 (S350), and executes the processes from S340 onward. Here, CPU may be configured to determine whether an object is detected in second detection region 92 and lower surface region 94, and suspend the movement of accommodation rack 80 for, for example, a predetermined period of time (3 seconds, 5 seconds, 10 seconds, or the like) as a temporary stop.

On the other hand, when no object is detected in the detecting region in S340, CPU determines whether an object is detected in warning region 93 (S360), and when an object is detected in waring region 93, CPU causes accommodation rack 80 to continue moving (S370). An object to be detected in warning region 93 is mainly loader 18, whereby replacement control section 59 can detect an approach of loader 18. Loader 18 suspends the movement along X-axis rail 19 when an object is detected in detection region 95. Since there may be a case in which, for example, caster section 84 enters detection region 95 while accommodation rack 80 stays inside the movement region, replacement control section 59 causes accommodation rack 80 to continue moving so that accommodation rack 80 moves out of detection region 95 without any delay.

After S370 or when no object is detected in waring region 93 in S360, CPU of replacement control section 59 determines whether accommodation rack 80 is at a predetermined lower limit height or lower (S380). This lower limit height is set to a height at which a member disposed on accommodation rack 80, for example, caster section 84 does not enter lower surface region 94. When accommodation rack 80 is not at the predetermined lower limit height or lower, CPU executes the processes from S330 onward. That is, after accommodation rack 80 has started to move, CPU executes the movement of accommodation rack 80 when no object is detected in second detection region 92 and lower surface region 94 and causes accommodation rack 80 to continue moving even though an object is detected in warning region 93. On the other hand, when accommodation rack 80 is at the lower limit height or lower in S380, the detection of an object by lower surface detection sections 57, 58 ends, and the determination of an existence of an object in lower surface region 94 also ends (S390). Then, CPU determines whether the movement of accommodation rack 80 to the standby position is completed (S400), and when the movement of accommodation rack 80 to the standby position has not yet been completed, CPU executes the processes from S330 onward. At this time, CPU omits the determination on whether an object exists in lower surface region 94 in S340. On the other hand, when the movement of accommodation rack 80 to the standby position is completed in S400, CPU ends the routine. In this manner, replacement unit 40 executes and restricts the movement of accommodation rack 80 while detecting an object existing on the circumference of replacement unit 40. In particular, after loader 18 has entered waring region 93, replacement unit 40 does not execute the movement of accommodation rack 80 from the replacement position and the standby position, whereby a risk of loader 18 suspending its movement is suppressed more. In addition, with replacement unit 40, a risk of an erroneous detection is suppressed more by switching the detection region between first detection region 91 and second detection region 92 in accordance with the position of accommodation rack 80.

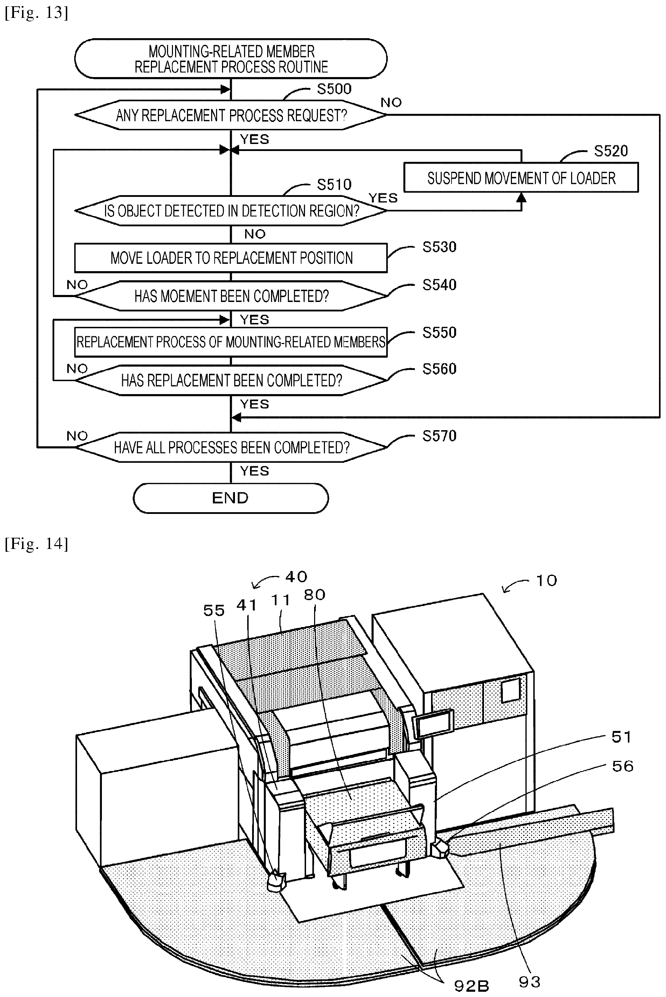

Next, a specific process of securing safety when loader 18 moves to replace mounting-related members will be described. Fig. 13 is a flowchart showing an example of a mounting-related member replacement process routine executed by CPU 71 of movement control section 70. This routine is stored in a storage section of movement control section 70 and is executed after loader 18 is activated. Here, a case will be described in which loader 18 automatically replaces feeders F as mounting-related members. When this routine is started, CPU 71 of movement control section 70 determines whether CPU 71 has received a replacement request of mounting-related members from host PC 14 (S500). When having received a replacement request, CPU 71 determines whether an object has been detected in detection region 95 (S510). CPU 71 executes this determination based on a detection signal from region detection section 76. Here, it need be understood that CPU 71 performs a detection of an object on a side of detection region 95 which faces the traveling direction of loader 18. When an object is detected in detection region 95, CPU 71 suspends the movement of loader 18 and executes the processes from S510 onward. CPU 71 may be configured to stop the movement of loader 18 for, for example, a predetermined period of time (3 seconds, 5 seconds, 10 seconds, or the like) as a temporary stop. On the other hand, when no object is detected in detection region 95 in S510, CPU 71 causes loader 18 to move to the replacement position of mounting-related members (S530). There are raised, for example, a front surface of an attachment section to which feeders F for subsequent use are attached, a front surface of an attachment section where used and collected feeders F are accumulated, and the like as the replacement position, and there are raised specifically an attachment section of storage device 13, buffer attachment section 63b of mounting device 15, and the like.

After S530, CPU 71 determines whether the movement of loader 18 has been completed based on the current position of loader 18 (S540), and executes the processes from S510 onward when the movement of loader 18 has not yet been completed. That is, loader 18 moves to the replacement position while suspending its movement when an object exists in detection region 95. When the movement of loader 18 is completed in S540, CPU 71 executes a replacement process of mounting-related members (S550). In the replacement process, CPU 71 executes loading and unloading operations of feeder F using replacement section 74. After S550, CPU 71 determines whether the replacement process has been completed (S560), and executes the processes from S550 onward when the replacement process has not yet been completed. That is, CPU 71 continues the replacement process. On the other hand, when the replacement process has been completed in S560, or when no replacement process request is made in S500, CPU 71 determines whether all the processes have been completed (S570). CPU 71 determines that all the processes have been completed when all the mounting processes at mounting devices 15 have been completed, when the power supply of mounting system 10 is switched off, or the like. When all the processes have not yet been completed, CPU 71 executes the processes from S500 onward, whereas when all the processes have been completed in S570, CUP 71 ends this routine.

In mounting system 10, when loader 18 approaches printing device 11, there may be a case in which the detection region of replacement unit 40 overlaps detection region 95. This tendency is increased particularly in a production line without print inspection device 12 and storage device 13. At this time, when accommodation rack 80 enters detection region 95, and loader 18 enters the detection region, there may be caused a locked state in which both the devices suspend the operation. With this mounting system 10, an approach of loader 18 is detected by detecting an object in warning region 93 by replacement unit 40 to thereby restrict the movement of accommodation rack 80, whereby the occurrence of such a locked state is prevented.

Here, correspondence relationships between the elements of the present embodiment and elements of the present disclosure will be clarified. Printing section 22 of the present embodiment corresponds to a printing section, rack moving section 43 corresponds to a moving section, region detection sections 55, 56 correspond to a region detection section, region detection section 56 corresponds to a device detection section, lower surface detection sections 57, 58 correspond to a lower surface detection section, and replacement control section 59 corresponds to a control section. In addition, first detection region 91 corresponds to a first detection region, second detection region 92 corresponds to a second detection region, warning region 93 corresponds to a warning region, lower surface region 94 corresponds to a lower surface region, and detection region 95 corresponds to a detection region. In addition, replacement unit 40 corresponds to a replacement unit, printing device 11 corresponds to a printing device, print inspection device 12, storage device 13, mounting device 15, and the like correspond to a mounting-related device, and loader 18 corresponds to a moving work device. Here, in the present embodiment, an example of a control method for a replacement unit according to the present disclosure is clarified by describing the operation of replacement unit 40.

In replacement unit 40 of the present embodiment that has been described heretofore, when accommodation rack 80 accommodating printing-related members exists outside the predetermined movement region lying between the standby position and the replacement position of accommodation rack 80, an object existing in predetermined first detection region 91 lying on the circumference of replacement unit 40 is detected, whereas when accommodation rack 80 exists inside the movement region , an object existing in second detection region 92 which is different from first detection region 91 is detected. With this replacement unit 40, since the detection region of an object can be changed appropriately in accordance with the position of accommodation rack 80, more safety can be secured for automatic replacement of printing-related members for use in printing device 11.

**In** addition, region detection sections 55, 56 define the region which avoids the member (for example, caster section 84) disposed on accommodation rack 80 as second detection region 92 when accommodation rack 80 exists inside the movement region. With this replacement unit 40, an erroneous detection of an object can be prevented more when accommodation rack 80 exists inside the movement region. Further, region detection sections 55, 56 define the region which includes the front surface of replacement unit 40 as first detection region 91 when accommodation rack 80 exists outside the movement region. With this replacement unit 40, a detection of an object can be executed in an appropriate region such as the replacement position, the standby position, and the like which lie outside the movement region. Furthermore, replacement unit 40 restricts the movement of accommodation rack 80 when an object is detected in first detection region 91 and/or second detection region 92. With this replacement unit 40, more safety can be secured by restricting the movement of accommodation rack 80 in accordance with an detection of an object.

**In** addition, replacement unit 40 includes lower surface detection sections 57, 58 for detecting an object existing in lower surface region 94 lying on the lower surface side of accommodation rack 80. With this replacement unit 40, an object existing below accommodation rack 80 can be detected, whereby more safety can be secured. Further, replacement unit 40 suspends the detection of an object by lower surface detection sections 57, 58 when accommodation rack 80 is in the standby position and at the predetermined height or lower and executes the detection of an object by lower surface detection sections 57, 58 when accommodation rack 80 is above the predetermined height. With this replacement unit 40, an erroneous detection of an object existing below accommodation rack 80 can be prevented more. Furthermore, replacement control section 59 does not execute the lowering of accommodation rack 80 when accommodation rack 80 is above the predetermined height and an object is detected by lower surface detection sections 57, 58. With this replacement unit 40, since a contact of accommodation rack 80 with an object existing therebelow can be prevented by prohibiting the lowering of accommodation rack 80, more safety can be secured.

In addition, replacement unit 40 includes left unit 41 disposed on the left-hand side of the housing of printing device 11 and right unit 51 disposed on the right-hand side of the housing, and has lifting and lowering space 49 defined between left unit 41 and right unit 51 to lift and lower accommodation rack 80, and region detection sections 55, 56 are disposed on each of left unit 41 and right unit 51 to detect an object existing on the circumference of replacement unit 40. With this replacement unit 40, an object existing on the circumference ranging from the left to right of printing device 11 can be detected, whereby more safety can be secured.

Further, replacement unit 40 is used in the mounting system including multiple mounting devices 15 which are involved in the process of mounting component P on the processing target object and loader 18 as the moving work device configured to move on the circumference of mounting device 15 when no object exists inside predetermined detection region 95 to automatically replace mounting-related members for use in mounting device 15. Then, replacement control section 59 causes rack moving section 43 to move accommodation rack 80 between the replacement position and the standby position. In addition, replacement control section 59 does not execute the movement of accommodation rack 80 when region detection section 56 as the device detection section detects an object in warning region 93 when accommodation rack 80 is not moving. There may be a case in which mounting system 10 includes loader 18 for automatically replacing members of mounting device 15 and replacement unit 40 for replacing members for use in printing device 11. Loader 18 is restricted from moving when an object exists in detection region 95 which constitutes a circumference of loader 18, whereas the movement of replacement unit 40 is also limited when an object exists inside the detection region. For example, when loader 18 enters the detection region of replacement unit 40 and accommodation rack 80 enters detection region 95 of loader 18, there may be caused a case in which the movements of both loader 18 and accommodation rack 80 are restricted, whereby the operations thereof are stopped. With this replacement unit 40, when region detection section 56 detects an object in warning region 93, replacement unit 40 determines that loader 18 is approaching, the movement of accommodation rack 80 is not executed, whereby the suspension of operations of both loader 18 and accommodation rack 80 can be prevented. Accordingly, with this replacement unit 40, the interference of the operations of both the devices can be suppressed as much as possible while securing more safety.

In addition, when region detection section 56 detects an existence of an object in warning region 93 while replacement control section 59 of replacement unit 40 is causing accommodation rack 80 to move to the replacement position, replacement control section 59 causes accommodation rack 80 to move to the replacement position and thereafter does not lower accommodation rack 80 from the replacement position while region detection section 56 continues to detect the existence of the object. With this replacement unit 40, accommodation rack 80 is prevented from entering detection region 95 of loader 18 by preventing accommodation rack 80 from being lowered, whereby the interference of the operations of both the devices can be suppressed as much as possible. Further, when region detection section 56 detects an existence of an object in warning region 93 while replacement control section 59 is causing accommodation rack 80 to move to the standby position, replacement control section 59 causes accommodation rack 80 to move to the standby position and thereafter does not execute the movement of accommodation rack 80 while region detection section 56 continues to detect the existence of the object. With this replacement unit 40, accommodation rack 80 is prevented from entering detection region 95 of loader 18 by preventing accommodation rack 80 from moving from the standby position, whereby the interference of the operations of both the devices can be suppressed as much as possible. Furthermore, in replacement unit 40, when accommodation rack 80 is in the replacement position and the standby position, accommodation rack 80 is outside detection region 95, whereas when accommodation rack 80 is in the predetermined movement region lying between the replacement position and the standby position, accommodation rack 80 is inside detection region 95, and when accommodation rack 80 is inside detection region 95, the movement of loader 18 is restricted. With this replacement unit 40, the interference of the operations of both the devices can be suppressed as much as possible in accordance with the position of accommodation rack 80. In addition, with this loader 18, since the movement thereof is limited in association with a detection of an object inside detection region 95, more safety can be secured.

In addition, in replacement unit 40, region detection section 56 defines the regions on the side of replacement unit 40 and the front surface sides of print inspection device 12, storage device 13, and mounting devices 15 which are the mounting-related devices as warning region 93. Further, warning region 93 includes the regions lying outside first detection region 91 and second detection region 92. With this replacement unit 40, loader 18 approaching the side of replacement unit 40 can be detected in advance. Further, in replacement unit 40, rack moving section 43 moves accommodation rack 80 between the lifting enabling position where accommodation rack 80 can be lifted up to the replacement position and the standby position where accommodation rack 80 is caused to enter the interior of the housing of printing device 11. With this replacement unit 40, since the accommodation rack enters the interior of the housing in the standby position, the region occupied by the accommodation rack can be reduced more, and the interference with the operation of another device can be reduced more. Furthermore, rack moving section 43 receives accommodation rack 80 which includes no power for moving printing-related members and on the lower surface side of which caster section 84 is disposed which has the casters able to run on the floor. With this replacement unit 40, accommodation rack 80 can be formed compact, and the interference with the operation of another device can be reduced more. In addition, with this accommodation rack 80, the movement thereof is facilitated by using the casters of caster section 84.

Here, the replacement unit, the printing device and the control method for a replacement unit according to the present disclosure are not limited at all to the embodiment described heretofore, and it is needless to say that they can be carried out in various embodiments without departing from the scope of the attached independent claims.

For example, in the embodiment described heretofore, replacement unit 40 includes lower surface detection sections 57, 58 for detecting an object existing on the lower surface side of accommodation rack 80; however the present disclosure is not particularly limited thereto, and these lower surface detection sections 57, 58 may be omitted. However, replacement unit 40 preferably includes lower surface detection sections 57, 58, so as to secure more safety.

In the embodiment described heretofore, replacement unit 40 is formed such that length A along the movement direction of frame 29 is shorter than length B of accommodation rack 80; however, the present disclosure is not particularly limited thereto. Here, since a printing process can be executed with accommodation rack 80 detached, replacement unit 40 with length A being smaller length B can make the device compact and is preferable.

In the embodiment described heretofore, replacement unit 40 includes left unit 41 and right unit 51 and has lifting and lowering space 49 defined therebetween to lift and lower accommodation rack 80; however the present disclosure is not particularly limited thereto, and replacement unit 40 may be formed into an integrated structure as long as the space for accommodating accommodation rack 80 is secured. In addition, replacement unit 40 is disposed on the front surface side of printing device 11; however, the present disclosure is not particularly limited thereto, and replacement unit 40 may be disposed on a rear side or a side surface side of printing device 11.

In the embodiment described heretofore, replacement unit 40 switches the detection region between first detection region 91 and second detection region 92 so as not only to suppress the erroneous detection of accommodation rack 80 but also to detect an approach of loader 18 in warning region 93; however, the present disclosure is not particularly limited thereto, and either of them may be omitted. In replacement unit 40, in the case that the detection region is switched between first detection region 91 and second detection region 92, the erroneous detection can be suppressed more, and in the case that warning region 93 is used, the operation locked state with loader 18 can be prevented.

In the embodiment described heretofore, replacement unit 40 moves accommodation rack 80 between the lifting enabling position where accommodation rack 80 is lifted up to the replacement position and the standby position where accommodation rack 80 is caused to enter the interior of the housing of printing device 11; however, the present disclosure is not particularly limited thereto. For example, with the lifting enabling position referred to as the standby position, replacement unit 40 may be configured to use second detection region 92 which avoids the member disposed on accommodation rack 80 in the standby position. Even with this replacement unit 40, more safety can be secured for automatic replacement of printing-related members for use in printing device 11.

In the embodiment described heretofore, second detection region 92 is defined as the region having the triangular blank region at the front of printing device 11; however, if second detection region 92 is defined as the region different from first detection region 91, the present disclosure is not particularly limited thereto, and for example, as shown in Fig. 14, second detection region 92 may be second detection region 92B having a rectangular blank region at the front of printing device 11 or second detection region having a polygonal, circular, or elliptic blank region at the front of printing device 11. The shape of the second detection region can be selected as required in accordance with the configuration of the device.

In the embodiment described heretofore, region detection section 56 is described as doubling as the device detection section of the present disclosure; however, the present disclosure is not particularly limited thereto, and replacement unit 40 may include a device detection section which is different from region detection section 56. In addition, in the embodiment described heretofore, region detection section 56 provided on right unit 51 is referred to as the device detection section; however, the present disclosure is not particularly limited thereto, and region detection section 55 may be referred to as the device detection section depending on the arrangement of the mounting-related devices.

In the embodiment described heretofore, warning region 93 is described as being configured such that the distance from region detection section 56 in the movement direction of loader 18 is determined in such a manner that the rack movement time is shorter than the loader movement time; however, the present disclosure is not particularly limited thereto, if warning region 93 is defined as a region which can detect an approach of the loader so as to avoid a locked state of operations of both the devices. Warning region 93 is preferably set as a region which can detect loader 18 before detection region 95 of loader 18 comes to overlap the movement region of accommodation rack 80.

In the embodiment described heretofore, accommodation rack 80 is described as having no drive section for moving frame 29; however, the present disclosure is not particularly limited thereto, and accommodation rack 80 may be configured as one having a drive section for moving frame 29.

In the embodiment described heretofore, the printing-related member is described as screen mask M; however, the present disclosure is not limited thereto as long as the printing-related member need be replaced, and the printing-related member may be one or more in cartridge 36 accommodating therein a viscous fluid, squeegee 25, cleaning member 34 for use for cleaning screen mask M, support member 32 for supporting board S as a processing target object, and the like, in addition to screen mask M. In addition, the processing target object is described as board S; however, the present disclosure is not particularly limited thereto, and a three-dimensional object or the like may be used if a viscous fluid is printed thereon. In addition, although the viscous fluid is described as the solder paste, conductive paste, an adhesive, or the like may be used.

In the embodiment described heretofore, the present disclosure discloses printing device 11 including replacement unit 40; however, the present disclosure is not particularly limited thereto, and the present disclosure may disclose replacement unit 40. When replacement unit 40 is distributed for connection with printing device 11, a similar advantageous effect provided by the embodiment that has been described heretofore can be provided. In addition, in the embodiment described heretofore, the present disclosure is described as disclosing printing device 11 including replacement unit 40; however, the present disclosure is not particularly limited thereto, and the present disclosure may disclose a control method for replacement unit 40.

The replacement unit, the printing device, the mounting system, the control method for a replacement unit according to the present disclosure are configured as follows. For example, the replacement unit of the present disclosure is a replacement unit for a printing device including a printing section configured to perform a printing process of printing a viscous fluid on a processing target object using a screen mask, the replacement unit including a moving section configured to receive an accommodation rack having multiple shelf sections for accommodating a printing-related member for use in the printing device and to move the accommodation rack between a replacement position where to replace the printing-related member and a standby position which lies further downwards than the replacement position, and a region detection section configured to detect an object existing in a predetermined first detection region lying around a circumference of the replacement unit when the accommodation rack exists outside a predetermined movement region which lies between the standby position and the replacement position and which excludes the standby position and the replacement position, while being configured to detect an object existing in a second detection region which is different from the first detection region when the accommodation rack exists inside the movement region, wherein the object includes an operator.

With this replacement unit, when the accommodation rack accommodating the printing-related members exists outside the predetermined movement region which lies between the standby position and the replacement position and which excludes the standby position and the replacement position, an object existing in the predetermined first detection region which lies around the circumference of the replacement unit is detected, whereas when the accommodation rack exists inside the movement region, an object existing in the second detection region which is different from the first detection region is detected. With this replacement unit, since the detection regions for objects can be changed appropriately in accordance with the position of the accommodation rack, more safety can be ensured for automatically replacing the printing-related members for use in the printing device.

Alternatively, the replacement unit of the present disclosure may be a replacement unit for a printing device used in a mounting system including multiple mounting-related devices involved in a process of mounting a component on a processing target object and a moving work device configured to move between the multiple mounting-related devices for automatic replacement of members for use in the mounting-related devices when no object exists inside a predetermined detection region and including a printing section configured to perform a printing process of printing a viscous fluid on a processing target object using a screen mask, the replacement unit including a moving section configured to receive an accommodation rack having multiple shelf sections for accommodating a printing-related member for use in the printing device and to move the accommodation rack between a replacement position where to replace the printing-related member and a standby position which lies further downwards than the replacement position, a device detection section configured to detect an object existing in a predetermined warning region where the moving work device moves, and a control section configured to cause the moving section to move the accommodation rack between the replacement position and the standby position, wherein the control section does not execute a movement of the accommodation rack when the device detection section detects an object in the warning region while the accommodation rack is not being caused to move.

There may be a case in which the mounting system includes the moving work device configured to automatically replace the members for use in the mounting-related devices and the replacement unit configured to replace the members for use in the printing device. The moving work device is restricted from moving when an object exists in the detection region which constitutes the circumference thereof, whereas the movement of the replacement unit is also limited when an object exists inside the detection region. For example, when the moving work device enters the detection region of the replacement unit and the accommodation rack enters the detection region of the moving work device, the movements of both the devices are limited, whereby there may be caused a case in which the operations of both the devices are suspended. With this replacement unit, when an object is detected in the warning region by the device detection section, the replacement unit determines that the moving work device is approaching, the movement of the accommodation rack is not executed, whereby the suspension of operations of both the devices can be prevented. Accordingly, with this replacement unit, not only more safety can be secured, but also an interference of operations of both the devices can be suppressed as much as possible.

The printing device of the present disclosure is a printing device including a printing section configured to perform a printing process of printing a viscous fluid on a processing target object using a screen mask and the replacement unit according to either of the replacement units described above. With this printing device, since the printing device includes the replacement unit according to either of the replacement units described above, as with the replacement units described above, not only more safety can be secured, but also the interference of operations of both the devices can be suppressed as much as possible. In addition, with this printing device, an advantageous effect according to the aspect of the replacement unit adopted can be obtained.

The control method for a replacement unit of the present disclosure is a control method for a replacement unit for a printing device including a printing section configured to perform a printing process of printing a viscous fluid on a processing target object using a screen mask, the replacement unit including a moving section configured to receive an accommodation rack having multiple shelf sections for accommodating a printing-related member for use in the printing device and to move the accommodation rack between a replacement position where to replace the printing-related member and a standby position which lies further downwards than the replacement position, the control method including:
(a) a step of detecting an object existing in a predetermined first detection region lying around a circumference of the replacement unit when the accommodation rack exists outside a predetermined movement region which lies between the standby position and the replacement position, and which excludes the standby position and the replacement position, while detecting an object existing in a second detection region which is different from the first detection region when the accommodation rack exists inside the movement region, wherein the object includes an operator; and
(b) a step of restricting the accommodation rack from moving when an object is detected in the first detection region and/or the second detection region.

As with the replacement units described above, with this control method for a replacement unit, since the detection region of an object can appropriately be changed in accordance with the position of the accommodation rack, more safety can be secured for automatic replacement of printing-related members for use in the printing device. Here, in this control method for a replacement unit, the various aspects of replacement units described above may be provided, or various steps that the replacement units execute may be added.

As with the replacement units described above, with this control method for a replacement unit, when an object is detected in the warning region by the device detection section, the control method determines that the moving work device is approaching, the movement of the accommodation rack is not executed, thereby making it possible to prevent the suspension of operations of both the devices. Accordingly, with this control method for a replacement unit, not only more safety can be secured, but also the interference of operations of both the devices can be suppressed as much as possible. Here, in this control method for a replacement unit, the various aspects of replacement units described above may be provided, or various steps that the replacement units execute may be added.

### Industrial Applicability

The present disclosure is applicable to the technical field of devices for performing a component mounting process.

### Reference Signs List

10 mounting system, 11 printing device, 12 print inspection device, 13 storage device, 14 host PC, 15 mounting device, 16 automatic conveyance vehicle, 17 management PC, 18 loader, 19 X-axis rail, 20 printing control section, 21 CPU, 22 printing section, 23 printing head, 24 print moving section, 25 squeegee, 26 mask work section, 27 replacement section, 28 mask fixing section, 29 frame, 30 board processing section, 31 board conveyance section, 32 support member, 33 cleaning section, 34 cleaning member, 35 fluid supply section, 36 cartridge, 37 rack detection section, 38 operation panel, 40 replacement unit, 41 left unit, 42 receiving section, 43 rack moving section, 44 lifting and lowering section, 44a cam follower, 45 lifting and lowering drive section, 47 hook portion, 48 forward-backward drive section, 49 lifting and lowering space, 50 fixing section, 51 right unit, 52 clamp lever, 53 insertion pin, 55, 56 region detection section, 57, 58 lower surface detection section, 59 replacement control section, 60 mounting control section, 60a CPU, 61 board processing section, 62 support member, 63 component supply section, 63a mounting attachment section, 63b buffer attachment section, 64 mounting section, 65 head moving section, 66 mounting head, 67 nozzle, 68 operation panel, 70 movement control section, 71 CPU, 73 accommodation section, 74 replacement section, 75 moving section, 76 region detection section, 80 accommodation rack, 80a rack main body, 81 shelf section, 82 opening section, 83 handle, 84 caster section, 85 supporting and fixing member, 86 block section, 87 receiving section, 88 locking hole, 89 insertion hole, 91 first detection region, 92, 92B second detection region, 93 warning region, 94 lower surface region, 95 detection region, A, B length, M screen mask, S board, P component, W operator.

## Claims

1. A replacement unit (40) for a printing device (11) comprising a printing section (22) configured to perform a printing process of printing a viscous fluid on a processing target object (S) using a screen mask (M),
the replacement unit (40) **characterized by** comprising:
a moving section (43) configured to receive an accommodation rack (80) having multiple shelf sections (81) for accommodating a printing-related member (25, 32, 34, 36, M) for use in the printing device (11) and to move the accommodation rack (80) between a replacement position where to replace the printing-related member (25, 32, 34, 36, M) and a standby position which lies further downwards than the replacement position; and
a region detection section (55, 56) configured to detect an object existing in a predetermined first detection region (91) lying around a circumference of the replacement unit (40) when the accommodation rack (80) exists outside a predetermined movement region which lies between the standby position and the replacement position and which excludes the standby position and the replacement position, while being configured to detect an object existing in a second detection region (92, 92B) which is different from the first detection region (91) when the accommodation rack (80) exists inside the movement region,
wherein the object includes an operator.

2. The replacement unit (40) according to claim 1,
wherein the second detection region (92, 92B) is defined as a region which avoids a member (84) forming part of the accommodation rack (80).

3. The replacement unit (40) according to claim 1 or 2,
wherein the first detection region (91) is defined as a region including a front surface of the replacement unit (40).

4. The replacement unit (40) according to any one of claims 1 to 3, further comprising:
a control section (59) configured to restrict a movement of the accommodation rack (80) when an object is detected in the first detection region (91) and/or the second detection region (92, 92B).

5. The replacement unit (40) according to any one of claims 1 to 4, further comprising:
a lower surface detection section (57, 58) configured to detect an object existing in a lower surface region on a lower surface side of the accommodation rack (80).

6. The replacement unit (40) according to claim 5, further comprising:
a control section (59) configured to control the moving section (43), suspend a detection of an object by the lower surface detection section (57, 58) when the accommodation rack (80) is in the standby position and at a predetermined height or lower, and execute a detection of an object by the lower surface detection section (57, 58) when the accommodation rack (80) is above the predetermined height.

7. The replacement unit (40) according to claim 6,
wherein the control section (59) does not execute lowering of the accommodation rack (80) when the accommodation rack (80) is above the predetermined height and an object is detected by the lower surface detection section (57, 58).

8. The replacement unit (40) according to any one of claims 1 to 7,
wherein the replacement unit (40) includes a first unit (41) to be disposed on one of a front left-hand side and a front right-hand side of a housing of the printing device (11) and a second unit (51) to be disposed on the other of the front left-hand side and the front right-hand side of the housing and comprises a lifting and lowering space (49) defined between the first unit (41) and the second unit (51) to lift and lower the accommodation rack (80), and
wherein the region detection section (55, 56) is disposed on each of the first unit (41) and the second unit (51) to detect an object existing on a circumference of the replacement unit (40).

9. The replacement unit (40) according to any one of claims 1 to 8, adapted for a mounting system (10) comprising one or more mounting-related devices (12, 13, 15) involved in a process of mounting a component (P) on a processing target object (S) and a moving work device (18) configured to move on a circumference of the mounting-related devices (12, 13, 15) for automatic replacement of members (25, 32, 34, 36, M) for use in the mounting-related devices (12, 13, 15) when no object exists in a predetermined detection region (95), and comprising:
a device detection section (56) configured to detect an object existing in a predetermined warning region (93) where the moving work device (18) moves; and
a control section (59) configured to cause the moving section (43) to move the accommodation rack (80) between the replacement position and the standby position,
wherein the control section (59) is configured not to execute a movement of the accommodation rack (80) when the device detection section (56) detects an existence of an object in the warning region (93) when the accommodation rack (80) is not being caused to move.

10. The replacement unit (40) according to claim 9,
wherein when the device detection section (56) detects an existence of an object in the warning region (93) while the control section (59) is causing the accommodation rack (80) to move to the replacement position, the control section (59) is configured to cause the accommodation rack (80) to move to the replacement position and thereafter not to cause the accommodation rack (80) to be lowered from the replacement position while the object is being detected by the device detection section (56), and/or
wherein when the device detection section (56) detects an existence of an object in the warning region (93) while the control section (59) is causing the accommodation rack (80) to move to the standby position, the control section (59) is configured to move the accommodation rack (80) to the standby position and thereafter not to execute a movement of the accommodation rack (80) while the object is being detected by the device detection section (56).

11. The replacement unit (40) according to claim 9 or 10,
wherein when the accommodation rack (80) is in the replacement position and the standby position, the accommodation rack (80) is outside the detection region (93), when the accommodation rack (80) is in a predetermined movement region lying between the replacement position and the standby position, the accommodation rack (80) is inside the detection region (93), and when the accommodation rack (80) is inside the detection region (93), a movement of the moving work device (18) is restricted.

12. The replacement unit (40) according to any one of claims 1 to 11,
wherein the moving section (43) is configured to move the accommodation rack (80) between a lifting enabling position where the accommodation rack (80) can be lifted up towards the replacement position and the standby position where the accommodation rack (80) is configured to enter an interior of the housing of the printing device (11).

13. The replacement unit (40) according to any one of claims 1 to 12,
wherein the moving section (43) receives the accommodation rack (80) which comprises no drive section for moving the printing-related member (25, 32, 34, 36, M) and on a lower surface side of which a caster (84) able to run on a floor is disposed.

14. A printing device (11) comprising:
a printing section (22) configured to perform a printing process of printing a viscous fluid on a processing target object (S) using a screen mask (M); and
the replacement unit (40) according to any one of claims 1 to 12.

15. A control method for a replacement unit (40) for a printing device (11) comprising a printing section (22) configured to perform a printing process of printing a viscous fluid on a processing target object (S) using a screen mask (M), the replacement unit (40) comprising a moving section (43) configured to receive an accommodation rack (80) having multiple shelf sections (81) for accommodating a printing-related member (25, 32, 34, 36, M) for use in the printing device (11) and to move the accommodation rack (80) between a replacement position where to replace the printing-related member (25, 32, 34, 36, M) and a standby position which lies further downwards than the replacement position, the control method comprising:
(a) a step of detecting an object existing in a predetermined first detection region (91) lying around a circumference of the replacement unit (40) when the accommodation rack (80) exists outside a predetermined movement region which lies between the standby position and the replacement position, and which excludes the standby position and the replacement position, while detecting an object existing in a second detection region (92, 92B) which is different from the first detection region (91) when the accommodation rack (80) exists inside the movement region, wherein the object includes an operator; and
(b) a step of restricting the accommodation rack (80) from moving when an object is detected in the first detection region (91) and/or the second detection region (92, 92B).

## Patentansprüche

1. Austauscheinheit (40) für eine Druckvorrichtung (11) mit einem Druckabschnitt (22), der so konfiguriert ist, dass er einen Druckvorgang zum Drucken einer viskosen Flüssigkeit auf ein zu bearbeitendes Zielobjekt (S) unter Verwendung einer Siebmaske (M) durchführt, wobei die Austauscheinheit (40) **dadurch gekennzeichnet ist, dass** sie umfasst:
einen Bewegungsabschnitt (43), der so konfiguriert ist, dass er ein Aufnahmegestell (80) mit mehreren Regalabschnitten (81) zur Aufnahme eines druckbezogenen Elements (25, 32, 34, 36, M) zur Verwendung in der Druckvorrichtung (11) aufnimmt und das Aufnahmegestell (80) zwischen einer Austauschposition, in der das druckbezogene Element (25, 32, 34, 36, M) ausgetauscht wird, und einer Standby-Position, die weiter unten als die Austauschposition liegt, bewegt; und
einen Bereichserfassungsabschnitt (55, 56), der so konfiguriert ist, dass er ein Objekt erfasst, das sich in einem vorbestimmten ersten Erfassungsbereich (91) befindet, der um einen Umfang der Austauscheinheit (40) herum liegt, wenn sich das Aufnahmegestell (80) außerhalb eines vorbestimmten Bewegungsbereichs befindet, der zwischen der Standby-Position und der Austauschposition liegt und die Standby-Position und die Austauschposition ausschließt, während er so konfiguriert ist, dass er ein Objekt erfasst, das in einem zweiten Erfassungsbereich (92, 92B) befindet, der sich vom ersten Erfassungsbereich (91) unterscheidet, wenn sich das Aufnahmegestell (80) innerhalb des Bewegungsbereichs befindet,
wobei das Objekt einen Bediener umfasst.

2. Austauscheinheit (40) nach Anspruch 1,
wobei der zweite Erfassungsbereich (92, 92B) als ein Bereich definiert ist, der ein Element (84) umgeht, das Teil des Aufnahmegestells (80) ist.

3. Austauscheinheit (40) nach Anspruch 1 oder 2,
wobei der erste Erfassungsbereich (91) als ein Bereich definiert ist, der eine Vorderseite der Austauscheinheit (40) umfasst.

4. Austauscheinheit (40) nach einem der Ansprüche 1 bis 3, die ferner umfasst:
einen Steuerabschnitt (59), der so konfiguriert ist, dass er eine Bewegung des Aufnahmegestell (80) einschränkt, wenn ein Objekt im ersten Erfassungsbereich (91) und/oder im zweiten Erfassungsbereich (92, 92B) erfasst wird.

5. Austauscheinheit (40) nach einem der Ansprüche 1 bis 4, die ferner umfasst:
einen unteren Oberflächenerfassungsabschnitt (57, 58), der so konfiguriert ist, dass er ein Objekt erfasst, das sich in einem unteren Oberflächenbereich auf einer unteren Oberflächenseite des Aufnahmegestells (80) befindet.

6. Austauscheinheit (40) nach Anspruch 5, die ferner umfasst:
einen Steuerabschnitt (59), der so konfiguriert ist, dass er den Bewegungsabschnitt (43) steuert, eine Erfassung eines Objekts durch den unteren Oberflächenerfassungsabschnitt (57, 58) aussetzt, wenn sich das Aufnahmegestell (80) in der Standby-Position und auf einer vorbestimmten Höhe oder darunter befindet, und eine Erfassung eines Objekts durch den unteren Oberflächenerfassungsabschnitt (57, 58) ausführt, wenn sich das Aufnahmegestell (80) über der vorbestimmten Höhe befindet.

7. Austauscheinheit (40) nach Anspruch 6,
wobei der Steuerabschnitt (59) das Absenken des Aufnahmegestells (80) nicht ausführt, wenn sich das Aufnahmegestell (80) über der vorbestimmten Höhe befindet und ein Objekt durch den unteren Oberflächenerfassungsabschnitt (57, 58) erfasst wird.

8. Austauscheinheit (40) nach einem der Ansprüche 1 bis 7,
wobei die Austauscheinheit (40) eine erste Einheit (41) umfasst, die entweder an der linken oder der rechten Vorderseite eines Gehäuses der Druckvorrichtung (11) angeordnet werden soll, und eine zweite Einheit (51), die an der jeweils anderen Seite der linken Vorderseite und der rechten Vorderseite des Gehäuses anzuordnen ist, und einen Anhebe- und Absenkraum (49) umfasst, der zwischen der ersten Einheit (41) und der zweiten Einheit (51) definiert ist, um das Aufnahmegestell (80) anzuheben und abzusenken, und
wobei der Bereichserfassungsabschnitt (55, 56) an jeder der ersten Einheit (41) und der zweiten Einheit (51) angeordnet ist, um ein Objekt zu erfassen, das sich an einem Umfang der Austauscheinheit (40) befindet.

9. Austauscheinheit (40) nach einem der Ansprüche 1 bis 8, die für ein Montagesystem (10) geeignet ist, das eine oder mehrere montagebezogene Vorrichtungen (12, 13, 15) umfasst, die an einem Prozess zum Montieren einer Komponente (P) an einem zu bearbeitenden Zielobjekt (S) beteiligt sind, sowie eine bewegliche Arbeitsvorrichtung (18), die so konfiguriert ist, dass sie sich auf einem Umfang der montagebezogenen Vorrichtungen (12, 13, 15) bewegt, um Elemente (25, 32, 34, 36, M) für die Verwendung in den montagebezogenen Vorrichtungen (12, 13, 15) automatisch auszutauschen, wenn sich kein Objekt in einem vorbestimmten Erfassungsbereich (95) befindet, und umfassend:
einen Geräteerfassungsabschnitt (56), der so konfiguriert ist, dass er ein Objekt erfasst, das sich in einem vorbestimmten Warnbereich (93) befindet, in dem sich die bewegliche Arbeitsvorrichtung (18) bewegt; und
einen Steuerabschnitt (59), der so konfiguriert ist, dass er den Bewegungsabschnitt (43) veranlasst, das Aufnahmegestell (80) zwischen der Austauschposition und der Standby-Position zu bewegen,
wobei der Steuerabschnitt (59) so konfiguriert ist, dass er keine Bewegung des Aufnahmegestells (80) ausführt, wenn der Geräteerfassungsabschnitt (56) das Vorhandensein eines Objekts im Warnbereich (93) erfasst, während das Aufnahmegestell (80) nicht bewegt wird.

10. Austauscheinheit (40) nach Anspruch 9,
wobei, wenn der Geräteerfassungsabschnitt (56) das Vorhandensein eines Objekts im Warnbereich (93) erfasst, während der Steuerabschnitt (59) bewirkt, dass sich das Aufnahmegestell (80) in die Austauschposition bewegt, der Steuerabschnitt (59) so konfiguriert ist, dass er bewirkt, dass sich das Aufnahmegestell (80) in die Austauschposition bewegt und danach nicht bewirkt, dass das Aufnahmegestell (80) aus der Austauschposition abgesenkt wird, während das Objekt vom Geräteerfassungsabschnitt (56) erfasst wird, und/oder
wobei, wenn der Geräteerfassungsabschnitt (56) das Vorhandensein eines Objekts im Warnbereich (93) erfasst, während der Steuerabschnitt (59) bewirkt, dass sich das Aufnahmegestell (80) in die Standby-Position bewegt, der Steuerabschnitt (59) so konfiguriert ist, dass er das Aufnahmegestell (80) in die Standby-Position bewegt und danach keine Bewegung des Aufnahmegestells (80) ausführt, während das Objekt vom Geräteerfassungsabschnitt (56) erfasst wird.

11. Austauscheinheit (40) nach Anspruch 9 oder 10,
wobei, wenn sich das Aufnahmegestell (80) in der Austauschposition und der Standby-Position befindet, sich das Aufnahmegestell (80) außerhalb des Erfassungsbereichs (93) befindet, wenn sich das Aufnahmegestell (80) in einem vorbestimmten Bewegungsbereich zwischen der Austauschposition und der Standby-Position befindet, sich das Aufnahmegestell (80) innerhalb des Erfassungsbereichs (93) befindet, und wenn sich das Aufnahmegestell (80) innerhalb des Erfassungsbereichs (93) befindet, eine Bewegung der beweglichen Arbeitsvorrichtung (18) eingeschränkt ist.

12. Austauscheinheit (40) nach einem der Ansprüche 1 bis 11,
wobei der Bewegungsabschnitt (43) so konfiguriert ist, dass er das Aufnahmegestell (80) zwischen einer Hebeposition, in der das Aufnahmegestell (80) in Richtung der Austauschposition angehoben werden kann, und der Standby-Position bewegt, in der das Aufnahmegestell (80) konfiguriert ist in das Innere des Gehäuses der Druckvorrichtung (11) einzufahren.

13. Austauscheinheit (40) nach einem der Ansprüche 1 bis 12,
wobei der Bewegungsabschnitt (43) das Aufnahmegestell (80) aufnimmt, welches keinen Antriebsabschnitt zum Bewegen des druckbezogenen Elements (25, 32, 34, 36, M) umfasst und an dessen Unterseite eine Rolle (84) angeordnet ist, die auf einem Boden laufen kann.

14. Druckvorrichtung (11), umfassend:
einen Druckabschnitt (22), der so konfiguriert ist, dass er einen Druckvorgang zum Drucken einer viskosen Flüssigkeit auf ein zu bearbeitendes Zielobjekt (S) unter Verwendung einer Siebmaske (M) durchführt; und
die Austauscheinheit (40) nach einem der Ansprüche 1 bis 12.

15. Steuerverfahren für eine Austauscheinheit (40) für eine Druckvorrichtung (11) mit einem Druckabschnitt (22), der so konfiguriert ist, dass er einen Druckvorgang zum Drucken einer viskosen Flüssigkeit auf ein zu bearbeitendes Zielobjekt (S) unter Verwendung einer Siebmaske (M) durchführt, wobei die Austauscheinheit (40) einen Bewegungsabschnitt (43) umfasst, der so konfiguriert ist, dass er ein Aufnahmegestell (80) mit mehreren Regalabschnitten (81) zur Aufnahme eines druckbezogenen Elements (25, 32, 34, 36, M) zur Verwendung in der Druckvorrichtung (11) aufnimmt und das Aufnahmegestell (80) zwischen einer Austauschposition, in der das druckbezogene Element (25, 32, 34, 36, M) ausgetauscht wird, und einer Standby-Position, die weiter unten als die Austauschposition liegt, bewegt, wobei das Steuerverfahren umfasst:
(a) einen Schritt zum Erfassen eines Objekts, das sich in einem vorbestimmten ersten Erfassungsbereich (91) befindet, der um einen Umfang der Austauscheinheit (40) herum liegt, wenn sich das Aufnahmegestell (80) außerhalb eines vorbestimmten Bewegungsbereichs befindet, der zwischen der Standby-Position und der Austauschposition liegt und die Standby-Position und die Austauschposition ausschließt, während ein Objekt erfasst wird, das sich in einem zweiten Erfassungsbereich (92, 92B) befindet, der sich von dem ersten Erfassungsbereich (91) unterscheidet, wenn sich das Aufnahmegestell (80) innerhalb des Bewegungsbereichs befindet, wobei das Objekt einen Bediener umfasst; und
(b) einen Schritt zum Einschränken der Bewegung des Aufnahmegestells (80), wenn ein Objekt im ersten Erfassungsbereich (91) und/oder im zweiten Erfassungsbereich (92, 92B) erfasst wird.

## Revendications

1. Unité de remplacement (40) pour un dispositif d'impression (11) comprenant une section d'impression (22) configurée pour mettre en œuvre un processus d'impression consistant à imprimer un fluide visqueux sur un objet cible de traitement (S) en utilisant un masque de filtrage (M), l'unité de remplacement (40) étant **caractérisée par le fait qu'**elle comprend :
une section de déplacement (43) configurée pour recevoir une baie d'accueil (80) comportant de multiples sections d'étagère (81) destinées à accueillir un élément lié à l'impression (25, 32, 34, 36, M) destiné à être utilisé dans le dispositif d'impression (11), et pour déplacer la baie d'accueil (80) entre une position de remplacement où l'élément lié à l'impression (25, 32, 34, 36, M) peut être remplacé et une position de veille située plus bas que la position de remplacement ; et
une section de détection de région (55, 56) configurée pour détecter un objet existant dans une première région de détection prédéterminée (91) située autour d'une circonférence de l'unité de remplacement (40) quand la baie d'accueil (80) existe à l'extérieur d'une région de déplacement prédéterminée située entre la position de veille et la position de remplacement et qui exclut la position de veille et la position de remplacement, tout en étant configurée pour détecter un objet existant dans une deuxième région de détection (92, 92B) qui est différente de la première région de détection (91) quand la baie d'accueil (80) existe à l'intérieur de la région de déplacement,
dans laquelle l'objet inclut un opérateur.

2. Unité de remplacement (40) selon la revendication 1, dans laquelle la deuxième région de détection (92, 92B) est définie comme une région qui évite un élément (84) faisant partie de la baie d'accueil (80).

3. Unité de remplacement (40) selon la revendication 1 ou 2,
dans laquelle la première région de détection (91) est définie comme une région incluant une surface avant de l'unité de remplacement (40).

4. Unité de remplacement (40) selon l'une quelconque des revendications 1 à 3, comprenant en outre :
une section de contrôle (59) configurée pour restreindre un déplacement de la baie d'accueil (80) quand un objet est détecté dans la première région de détection (91) et/ou dans la deuxième région de détection (92, 92B).

5. Unité de remplacement (40) selon l'une quelconque des revendications 1 à 4, comprenant en outre :
une section de détection de surface inférieure (57, 58) configurée pour détecter un objet existant dans une région de surface inférieure sur un côté de surface inférieure de la baie d'accueil (80).

6. Unité de remplacement (40) selon la revendication 5, comprenant en outre :
une section de contrôle (59) configurée pour contrôler la section de déplacement (43), pour suspendre la détection d'un objet par la section de détection de surface inférieure (57, 58) quand la baie d'accueil (80) est en position de veille et se trouve à une hauteur inférieure ou égale à une hauteur prédéterminée, et pour exécuter la détection d'un objet par la section de détection de surface inférieure (57, 58) quand la baie d'accueil (80) se trouve plus haut que la hauteur prédéterminée.

7. Unité de remplacement (40) selon la revendication 6, dans laquelle la section de contrôle (59) n'effectue pas un abaissement de la baie d'accueil (80) quand la baie d'accueil (80) se trouve plus haut que la hauteur prédéterminée et qu'un objet est détecté par la section de détection de surface inférieure (57, 58).

8. Unité de remplacement (40) selon l'une quelconque des revendications 1 à 7,
dans laquelle l'unité de remplacement (40) inclut une première unité (41) à disposer sur un côté parmi le côté avant gauche et le côté avant droit du boîtier du dispositif d'impression (11) et une deuxième unité (51) à disposer sur l'autre côté parmi le côté avant gauche et le côté avant droit du boîtier, et comprend un espace de levage et d'abaissement (49) défini entre la première unité (41) et la deuxième unité (51) pour lever et abaisser la baie d'accueil (80), et
dans laquelle la section de détection de région (55, 56) est disposée sur chaque unité parmi la première unité (41) et la deuxième unité (51) pour détecter un objet existant sur une circonférence de l'unité de remplacement (40).

9. Unité de remplacement (40) selon l'une quelconque des revendications 1 à 8, adaptée à un système de montage (10) comprenant un ou plusieurs dispositifs liés au montage (12, 13, 15) impliqués dans un processus de montage d'un composant (P) sur un objet cible de traitement (S) et un dispositif de travail de déplacement (18) configuré pour se déplacer sur la circonférence des dispositifs liés au montage (12, 13, 15) pour le remplacement automatique des éléments (25, 32, 34, 36, M) destinés à être utilisés dans les dispositifs liés au montage (12, 13, 15) quand aucun objet n'existe dans une région de détection prédéterminée (95), et comprenant :
une section de détection de dispositif (56) configurée pour détecter un objet existant dans une région d'avertissement prédéterminée (93) où se déplace le dispositif de travail de déplacement (18) ; et
une section de contrôle (59) configurée pour commander à la section de déplacement (43) de déplacer la baie d'accueil (80) entre la position de remplacement et la position de veille,
dans laquelle la section de contrôle (59) est configurée pour ne pas exécuter un déplacement de la baie d'accueil (80) quand la section de détection de dispositif (56) détecte l'existence d'un objet dans la région d'avertissement (93) lorsqu'il n'y a pas de commande de déplacement de la baie d'accueil (80).

10. Unité de remplacement (40) selon la revendication 9, dans laquelle, quand la section de détection de dispositif (56) détecte l'existence d'un objet dans la région d'avertissement (93) alors que la section de contrôle (59) commande le déplacement de la baie d'accueil (80) jusqu'à la position de remplacement, la section de contrôle (59) est configurée pour commander le déplacement de la baie d'accueil (80) jusqu'à la position de remplacement et, ensuite, pour ne pas commander l'abaissement de la baie d'accueil (80) depuis la position de remplacement alors que l'objet est détecté par la section de détection de dispositif (56), et/ou
dans laquelle, quand la section de détection de dispositif (56) détecte l'existence d'un objet dans la région d'avertissement (93) alors que la section de contrôle (59) commande le déplacement de la baie d'accueil (80) jusqu'à la position de veille, la section de contrôle (59) est configurée pour déplacer la baie d'accueil (80) jusqu'à la position de veille et ensuite pour ne pas exécuter un déplacement de la baie d'accueil (80) alors que l'objet est détecté par la section de détection de dispositif (56).

11. Unité de remplacement (40) selon la revendication 9 ou 10,
dans laquelle, quand la baie d'accueil (80) se trouve dans la position de remplacement et dans la position de veille, la baie d'accueil (80) se trouve en dehors de la région de détection (93), quand la baie d'accueil (80) se trouve dans une région de déplacement prédéterminée située entre la position de remplacement et la position de veille, la baie d'accueil (80) se trouve à l'intérieur de la région de détection (93), et quand la baie d'accueil (80) se trouve à l'intérieur de la région de détection (93), le déplacement du dispositif de travail de déplacement (18) est restreint.

12. Unité de remplacement (40) selon l'une quelconque des revendications 1 à 11,
dans laquelle la section de déplacement (43) est configurée pour déplacer la baie d'accueil (80) entre une position d'habilitation de levage, où la baie d'accueil (80) peut être levée vers la position de remplacement, et la position de veille, où la baie d'accueil (80) est configurée pour entrer à l'intérieur du boîtier du dispositif d'impression (11).

13. Unité de remplacement (40) selon l'une quelconque des revendications 1 à 12,
dans laquelle la section de déplacement (43) reçoit la baie d'accueil (80), qui ne comprend aucune section d'entraînement pour déplacer l'élément lié à l'impression (25, 32, 34, 36, M), sur un côté de surface inférieure de laquelle est disposée une roulette (84) capable de rouler sur un sol.

14. Dispositif d'impression (11) comprenant :
une section d'impression (22) configurée pour mettre en œuvre un processus d'impression consistant à imprimer un fluide visqueux sur un objet cible de traitement (S) en utilisant un masque de filtrage (M) ; et
l'unité de remplacement (40) selon l'une quelconque des revendications 1 à 12.

15. Procédé de contrôle d'une unité de remplacement (40) pour un dispositif d'impression (11), comprenant une section d'impression (22) configurée pour mettre en œuvre un processus d'impression consistant à imprimer un fluide visqueux sur un objet cible de traitement (S) en utilisant un masque de filtrage (M), l'unité de remplacement (40) comprenant une section de déplacement (43) configurée pour recevoir une baie d'accueil (80) comportant de multiples sections d'étagère (81) pour accueillir un élément lié à l'impression (25, 32, 34, 36, M) destiné à être utilisé dans le dispositif d'impression (11), et pour déplacer la baie d'accueil (80) entre une position de remplacement où l'élément lié à l'impression (25, 32, 34, 36, M) peut être remplacé et une position de veille située plus bas que la position de remplacement, le procédé de contrôle comprenant :
(a) une étape de détection d'un objet existant dans une première région de détection prédéterminée (91) située autour d'une circonférence de l'unité de remplacement (40) quand la baie d'accueil (80) existe en dehors d'une région de déplacement prédéterminée située entre la position de veille et la position de remplacement, et qui exclut la position de veille et la position de remplacement, tout en détectant un objet existant dans une deuxième région de détection (92, 92B) différente de la première région de détection (91) quand la baie d'accueil (80) existe à l'intérieur de la région de déplacement, dans laquelle l'objet inclut un opérateur ; et
(b) une étape consistant à restreindre le déplacement de la baie d'accueil (80) quand un objet est détecté dans la première région de détection (91) et/ou dans la deuxième région de détection (92, 92B).
